(19) **Europäisches Patentamt**
**European Patent Office**
**Office européen des brevets**

(11) **EP 4 674 822 A1**

(12) **EUROPEAN PATENT APPLICATION**
published in accordance with Art. 153(4) EPC

(43) Date of publication:
**07.01.2026 Bulletin 2026/02**

(21) Application number: **24923602.7**

(22) Date of filing: **31.12.2024**

(51) International Patent Classification (IPC):
*C03C 10/04* (2006.01)      *H05K 5/03* (2006.01)
*H05K 5/02* (2006.01)      *C03C 21/00* (2006.01)

(86) International application number:
**PCT/CN2024/144670**

(87) International publication number:
**WO 2025/167400 (14.08.2025 Gazette 2025/33)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **07.02.2024 CN 202410175049**

(71) Applicant: **Chongqing Aureavia Hi-Tech Glass
Co., Ltd.
Chongqing 400714 (CN)**

(72) Inventor: **LONG, Chenhui
Chongqing 400714 (CN)**

(74) Representative: **Mitola, Marco et al
Jacobacci & Partners S.p.A.
Piazza Mario Saggin, 2
35131 Padova (IT)**

(54) **GLASS-CERAMIC, CHEMICALLY STRENGTHENED GLASS-CERAMIC, COVER PLATE GLASS AND ELECTRONIC DEVICE**

(57)     Provided are a microcrystalline glass, a chemically strengthened microcrystalline glass, a cover glass and an electronic device, relating to the technical field of microcrystalline glass. By controlling specific composition and crystalline phase structure of the microcrystalline glass, specific ranges of contents of various components of the microcrystalline glass and a proportioning relationship between the contents of various components, specific molar percentage relationships between $Na_2O$, $B_2O_3$, $ZrO_2$ or $Li_2O$, and lithium disilicate as a predominant crystalline phase of the microcrystalline glass at the same time, it not only can endow the microcrystalline glass with excellent optical properties and high intrinsic strength, but also enables the microcrystalline glass to achieve rapid and efficient production of the chemically strengthened microcrystalline glass having a high stress level and high mechanical strength performance under conventional chemical strengthening process conditions.

FIG. 1

EP 4 674 822 A1

**Description**

**CROSS-REFERENCE TO RELATED APPLICATIONS**

The present invention claims the priority to Chinese patent application with the filing No. 202410175049.4 filed on February 7, 2024 with the China National Intellectual Property Administration, and entitled "MICROCRYSTALLINE GLASS, CHEMICALLY STRENGTHENED MICROCRYSTALLINE GLASS, COVER GLASS AND ELECTRONIC DEVICE", the contents of which are incorporated herein by reference in entirety.

**TECHNICAL FIELD**

The present invention relates to the technical field of microcrystalline glass, and specifically to a microcrystalline glass, a chemically strengthened microcrystalline glass, a cover glass and an electronic device.

**BACKGROUND ART**

Microcrystalline glass is a solid composite material formed through controlled crystallization of substrate glass in a heat treatment process. Microcrystalline glass includes a microcrystalline phase and a glass phase. Compared with glass materials without the microcrystalline phase, the microcrystalline glass generally has higher strength, because the microcrystalline phase has higher strength than the glass phase, absorbs more energy during fracture, and can prolong a crack propagation path and hinder crack propagation, and thus can dissipate more impact energy during fracture and fragmentation.

In recent years, microcrystalline glass has been gradually applied in a variety of electronic devices, such as mobile phones, watches, pads, notebook computers, electronic book readers or other like devices, as cover glass for the electronic devices, such as cover glass for display screens and cover glass for rear housings of the electronic devices. For display screens of electronic devices, cover glass is typically required to have good optical properties, small thickness and high mechanical performance. In order to further improve the mechanical performance of microcrystalline glass, it is generally necessary to perform chemical strengthening treatment on the microcrystalline glass, so as to produce chemically strengthened microcrystalline glass having a high stress level, high mechanical strength and high damage resistance performance through ion exchange.

Therefore, how to optimize chemical strengthening effects of microcrystalline glass while maintaining excellent optical properties, and realize rapid and efficient production of chemically strengthened microcrystalline glass having a high stress level and high mechanical strength performance is a critical technical problem to be solved urgently by those skilled in the art.

**SUMMARY**

As microcrystalline glass exhibits distinct structural differences from glass materials without microcrystalline phase, difficulties of chemical strengthening thereof are also different. In order to prepare and obtain high-strength chemically strengthened microcrystalline glass having a high stress level and high mechanical strength performance and meeting application requirements for optical properties of cover glass, those skilled in the art typically would choose to subject existing microcrystalline glass to a prolonged chemical strengthening treatment, or to perform a chemical strengthening treatment on existing microcrystalline glass using a high-temperature (for example, exceeding 480 °C) molten salt bath. Both prolonging the strengthening time and elevating the molten salt bath temperature will lead to increased chemical strengthening costs of microcrystalline glass, that is, raising production costs of high-strength chemically strengthened microcrystalline glass.

The present invention aims at providing microcrystalline glass having excellent optical properties and high intrinsic strength by adjusting composition and structure of the microcrystalline glass, and enabling the microcrystalline glass to achieve rapid and efficient production of chemically strengthened microcrystalline glass having a high stress level, excellent mechanical strength performance, and superior damage resistance performance under conventional chemical strengthening process conditions.

In order to achieve the above objectives, the present invention provides technical solutions as follows.

In the first aspect, a microcrystalline glass is provided, where the microcrystalline glass includes a lithium disilicate crystalline phase, where the lithium disilicate crystalline phase has a higher weight percentage than other crystalline phases present in the microcrystalline glass;

in terms of molar percentage of oxides, the microcrystalline glass includes components as follows: $SiO_2$: 61.50%-63.40%, $Al_2O_3$: 2.75%-2.99%, $P_2O_5$: 0.91%-1.91%, $ZrO_2$: 4.20%-4.85%, $Na_2O$: 1.80%-3.20%, $B_2O_3$:

0-1.00% and Li$_2$O: 25.32%-26.52%; and

in composition of the microcrystalline glass, a molar percentage [Na$_2$O] of Na$_2$O, a molar percentage [B$_2$O$_3$] of B$_2$O$_3$ and a molar percentage [ZrO$_2$] of ZrO$_2$ satisfy the following relationship:

Z=-1.344×(2.65-100×[Na$_2$O])$^2$+0.466×100×[B$_2$O$_3$]+1.203×100×[ZrO$_2$],  where  4.80≤Z≤5.35,  preferably, 4.98≤Z≤5.20.

By controlling the specific composition and crystalline phase structure of the microcrystalline glass, specific ranges of contents of various components of the microcrystalline glass and the proportioning relationship between the contents of various components, specific molar percentage relationships between Na$_2$O, B$_2$O$_3$, ZrO$_2$ or Li$_2$O, and lithium disilicate as the predominant crystalline phase of the microcrystalline glass at the same time, the microcrystalline glass not only can be endowed with excellent optical properties and high intrinsic strength, but also the microcrystalline glass is enabled to achieve rapid and efficient production of the chemically strengthened microcrystalline glass having a high stress level and high mechanical strength performance under conventional chemical strengthening process conditions.

In some embodiments, in the composition of the microcrystalline glass, the molar percentage [Na$_2$O] of Na$_2$O and the molar percentage [B$_2$O$_3$] of B$_2$O$_3$ satisfy the following relationship:

0.90%≤[Na$_2$O]-[B$_2$O$_3$]≤3.10%,  preferably  1.25%≤[Na$_2$O]-[B$_2$O$_3$]≤3.02%,  and  more  preferably 2.00%≤[Na$_2$O]-[B$_2$O$_3$]≤3.00%.

In some embodiments, in the composition of the microcrystalline glass, the molar percentage [Na$_2$O] of Na$_2$O and the molar percentage [Li$_2$O] of Li$_2$O satisfy the following relationship:

8.55≤[Li$_2$O]/[Na$_2$O]≤13.85, preferably 8.55≤[Li$_2$O]/[Na$_2$O]≤11.50.

In some embodiments, the lithium disilicate crystalline phase accounts for 70% or more by weight of all crystalline phases of the microcrystalline glass, and preferably, the lithium disilicate crystalline phase accounts for 85% or more by weight of all the crystalline phases of the microcrystalline glass.

In some embodiments, in terms of molar percentage of oxides, in the microcrystalline glass:

a molar percentage of SiO$_2$ is 61.50%-63.30%, preferably, the molar percentage of SiO$_2$ is 62.00%-62.60%; and/or a molar percentage of P$_2$O$_5$ is 1.20%-1.91%, and preferably, the molar percentage of P$_2$O$_5$ is 1.30%-1.60%; and/or the molar percentage of Na$_2$O is 1.85%-3.05%, and preferably, the molar percentage of Na$_2$O is 2.20%-3.00%; and/or the molar percentage of B$_2$O$_3$ is 0-0.65%; and/or the molar percentage of ZrO$_2$ is 4.20%-4.80%; and/or a molar percentage of Li$_2$O is 25.52%-26.52%, and preferably, the molar percentage of Li$_2$O is 25.52%-26.00%.

In some embodiments, in terms of molar percentage of oxides, in the microcrystalline glass:

a molar percentage of SiO$_2$ is 62.88%, 63.30%, 62.50%, 63.26%, 62.38%, 62.27%, 62.45%, 62.22% or 63.17%; and/or

a molar percentage of Al$_2$O$_3$ is 2.86%, 2.87%, 2.93%, 2.94% or 2.99%; and/or a molar percentage of P$_2$O$_5$ is 1.00%, 1.20%, 1.30%, 1.60%, 1.40%, 1.41%, 1.53% or 1.54%; and/or the molar percentage of ZrO$_2$ is 4.80%, 4.74%, 4.84%, 4.33%, 4.34% or 4.35%; and/or the molar percentage of Na$_2$O is 1.85%, 2.35%, 1.95%, 2.36%, 2.96%, 3.01%, 2.93% or 2.95%; and/or a molar percentage of Li$_2$O is 25.62%, 25.82%, 25.69%, 25.36%, 25.77%, 25.87%, 25.90%, 25.79%, 26.03% or 25.74%.

In some embodiments, in terms of content expressed in molar percentage of oxides, the composition of the microcrystalline glass satisfies:

a value of equation Z is 5.19, 5.10, 5.09, 5.06 or 5.13; and/or a value of [Na$_2$O]-[B$_2$O$_3$] is 1.26%, 1.79%, 0.96%, 2.36%, 2.96%, 3.01%, 2.93% or 2.95%; and/or a value of [Li$_2$O]/[Na$_2$O] is 13.83, 10.93, 13.01, 10.92, 8.73, 8.61, 8.79 or 8.83.

In some embodiments, crystallinity of the microcrystalline glass is not lower than 45%, preferably, the crystallinity of the microcrystalline glass is 45%-85%, and more preferably, the crystallinity of the microcrystalline glass is 55%-65%; and/or

in the microcrystalline glass, an average grain size is not larger than 100 nm, preferably, the average grain size is not larger than 40 nm, and more preferably, the average grain size is 15-30 nm.

In some embodiments, the microcrystalline glass is transparent within a visible light wavelength range; preferably, at a thickness of 0.70 mm, for light with a wavelength of 550 nm, transmittance of the microcrystalline glass is ≥90.00%, and preferably the transmittance is >90.40%; and/or at the thickness of 0.70 mm, haze of the microcrystalline glass is <0.30%.

In some embodiments, at a thickness of 0.70 mm, a b value of the microcrystalline glass is <0.70, and preferably, the b value is ≤0.60.

In some embodiments, Young's modulus of the microcrystalline glass is ≥100 GPa, and preferably, the Young's modulus of the microcrystalline glass is 105-112.50 GPa; and/or

Vickers hardness of the microcrystalline glass is ≥640 kgf/mm$^2$, and preferably, the Vickers hardness of the microcrystalline glass is 640-680 kgf/mm$^2$.

In some embodiments, the microcrystalline glass includes planar microcrystalline glass or curved microcrystalline glass; and preferably, when the microcrystalline glass is the curved microcrystalline glass, the microcrystalline glass can be fabricated by performing a 3D hot bending treatment on a crystallized glass precursor with crystallinity not lower than 5%.

In some embodiments, the microcrystalline glass is fabricated from substrate glass through a heat treatment; preferably, the heat treatment process includes a nucleation treatment and/or a crystallization treatment; preferably, the crystallization treatment includes one-step crystallization treatment or two-step crystallization treatment; preferably, the curved microcrystalline glass can be fabricated through the two-step crystallization treatment, where when the two-step crystallization treatment is employed, a second step of the crystallization treatment includes heating a crystallized glass precursor obtained from a first step of crystallization treatment to a crystallization temperature and performing a 3D hot bending treatment, and performing a secondary crystallization in a 3D hot bending process.

In some embodiments, a thickness of the microcrystalline glass is 0.10-5.00 mm.

In the second aspect, a chemically strengthened microcrystalline glass is provided, where the chemically strengthened microcrystalline glass is fabricated from the microcrystalline glass according to any embodiment in the first aspect through a chemical strengthening treatment, where composition at a center of the chemically strengthened microcrystalline glass is identical to that of the microcrystalline glass according to any embodiment in the first aspect, and the chemically strengthened microcrystalline glass includes a compression stress layer region extending from a surface of the chemically strengthened microcrystalline glass to a compression depth, and there is a tensile stress inside the chemically strengthened microcrystalline glass, that is, the chemically strengthened microcrystalline glass includes a compression stress layer and a tensile stress layer.

In some embodiments, the chemically strengthened microcrystalline glass includes a lithium disilicate crystalline phase, where the lithium disilicate crystalline phase accounts for a higher weight percentage than other crystalline phases present in the chemically strengthened microcrystalline glass; and in terms of molar percentage of oxides, components at the center of the chemically strengthened microcrystalline glass include: $SiO_2$: 61.50%-63.40%, $Al_2O_3$: 2.75%-2.99%, $P_2O_5$: 0.91%-1.91%, $ZrO_2$: 4.20%-4.85%, $Na_2O$: 1.80%-3.20%, $B_2O_3$: 0-1.00% and $Li_2O$: 25.32%-26.52%; and

in the composition at the center of the chemically strengthened microcrystalline glass, the molar percentage $[Na_2O]$ of $Na_2O$, the molar percentage $[B_2O_3]$ of $B_2O_3$ and the molar percentage $[ZrO_2]$ of $ZrO_2$ satisfy the following relationship: $Z=-1.344\times(2.65-100\times[Na_2O])^2+0.466\times100\times[B_2O_3]+1.203\times100\times[ZrO_2]$, 4.80≤Z≤5.35, preferably, 4.98≤Z≤5.20.

In some embodiments, in the composition at the center of the chemically strengthened microcrystalline glass, the molar percentage $[Na_2O]$ of $Na_2O$ and the molar percentage $[B_2O_3]$ of $B_2O_3$ satisfy the following relationship: 0.90%≤$[Na_2O]$-$[B_2O_3]$≤3.10%, preferably, 1.25%≤$[Na_2O]$-$[B_2O_3]$≤3.02%, and more preferably, 2.00%≤$[Na_2O]$-$[B_2O_3]$≤3.00%; and/or

in the composition at the center of the chemically strengthened microcrystalline glass, the molar percentage $[Na_2O]$ of $Na_2O$ and the molar percentage $[Li_2O]$ of $Li_2O$ satisfy the following relationship: 8.55≤$[Li_2O]$/$[Na_2O]$≤13.85, and preferably, 8.55≤$[Li_2O]$/$[Na_2O]$≤11.50.

In some embodiments, the chemically strengthened microcrystalline glass has CT_LD of 45,000-55,000 MPa/mm, where the CT_LD is tensile stress linear density, and preferably, the chemically strengthened microcrystalline glass has the CT_LD of 48,000-53,000 MPa/mm; and/or

the chemically strengthened microcrystalline glass has DOL_0 of 0.18 t-0.25 t, where the DOL_0 is a depth of the compression stress layer, and t is a thickness of the chemically strengthened microcrystalline glass, and preferably, the chemically strengthened microcrystalline glass has the DOL_0 of 0.20 t-0.25 t; and/or

the chemically strengthened microcrystalline glass has CS_50 of 150-199 MPa, where the CS_50 refers to a compressive stress value at a depth of 50 μm from a main surface of the chemically strengthened microcrystalline glass, and preferably, the chemically strengthened microcrystalline glass has the CS_50 of 160-199 MPa; and/or

the chemically strengthened microcrystalline glass has |CT_AV| of 80-98 MPa, where the |CT_AV| is an absolute value of an average tensile stress; and/or

the chemically strengthened microcrystalline glass has |CT_CV| of 115-142 MPa, where the |CT_CV| is an absolute value of a maximum tensile stress, and preferably, the chemically strengthened microcrystalline glass has the |CT_CV| of 120-140 MPa.

In some embodiments, Vickers hardness of the chemically strengthened microcrystalline glass is ≥680 kgf/mm$^2$,

and preferably, the Vickers hardness of the chemically strengthened microcrystalline glass is 700 kgf/mm$^2$-800 kgf/mm$^2$.

In the third aspect, a glass article is provided, where the glass article includes the microcrystalline glass according to any embodiment in the first aspect or the chemically strengthened microcrystalline glass according to any embodiment in the second aspect.

In the fourth aspect, a cover glass is provided, where the cover glass is fabricated from the microcrystalline glass according to any embodiment in the first aspect or the chemically strengthened microcrystalline glass according to any embodiment in the second aspect, that is, the cover glass includes the microcrystalline glass according to any embodiment in the first aspect or the chemically strengthened microcrystalline glass according to any embodiment in the second aspect. The cover glass may be a display screen cover plate, a rear housing or a camera protection cover plate of an electronic device.

In the fifth aspect, an electronic device is provided, where the electronic device includes the microcrystalline glass according to any embodiment in the first aspect or the chemically strengthened microcrystalline glass according to any embodiment in the second aspect.

In some embodiments, the electronic device includes a casing assembled outside the electronic device, and a circuit board located inside the casing, where the casing includes the microcrystalline glass according to any embodiment in the first aspect or the chemically strengthened microcrystalline glass according to any embodiment in the second aspect.

In some embodiments, the casing includes a display screen cover plate assembled on a front side of the electronic device, where the display screen cover plate includes the microcrystalline glass according to any embodiment in the first aspect or the chemically strengthened microcrystalline glass according to any embodiment in the second aspect.

In some embodiments, the casing includes a rear housing assembled on a rear side of the electronic device, where the rear housing includes the microcrystalline glass according to any embodiment in the first aspect or the chemically strengthened microcrystalline glass according to any embodiment in the second aspect.

In some embodiments, the electronic device further includes a camera assembly located inside the casing, and the casing includes a camera protection cover plate, where the camera protection cover plate is covered over the camera assembly, and the camera protection cover plate includes the microcrystalline glass according to any embodiment in the first aspect or the chemically strengthened microcrystalline glass according to any embodiment in the second aspect.

In some embodiments, the electronic device further includes a mid-frame located between the display module and the casing, where the mid-frame includes the microcrystalline glass according to any embodiment in the first aspect or the chemically strengthened microcrystalline glass according to any embodiment in the second aspect.

In some embodiments, the casing may partly employ the microcrystalline glass or chemically strengthened microcrystalline glass, or completely employ the microcrystalline glass or chemically strengthened microcrystalline glass. In the electronic device in the present invention, some of the display screen cover plate, the rear housing, the camera protection cover plate, and the mid-frame may employ the microcrystalline glass according to any embodiment in the first aspect or the chemically strengthened microcrystalline glass according to any embodiment in the second aspect.

One or more of the above technical solutions provided by the present invention include advantages as follows.

By controlling the specific composition and crystalline phase structure of the microcrystalline glass, specific ranges of contents of various components of the microcrystalline glass and the proportioning relationship between the contents of various components, specific molar percentage relationships between $Na_2O$, $B_2O_3$, $ZrO_2$ or $Li_2O$, and lithium disilicate as a predominant crystalline phase of the microcrystalline glass at the same time, the present invention not only can endow the microcrystalline glass with excellent optical properties and high intrinsic strength, but also enables the microcrystalline glass to achieve rapid and efficient production of the chemically strengthened microcrystalline glass having a high stress level and high mechanical strength performance under conventional chemical strengthening process conditions, thereby being capable of effectively reducing production costs of the high-strength chemically strengthened microcrystalline glass.

## BRIEF DESCRIPTION OF DRAWINGS

In order to more clearly illustrate technical solutions of embodiments of the present invention, drawings which need to be used in the embodiments will be briefly introduced below. It should be understood that the drawings merely show some embodiments of the present invention, and thus should not be considered as limitation to the scope. Those ordinarily skilled in the art still could obtain other relevant drawings according to these drawings, without using inventive efforts.

FIG. 1 is an XRD pattern of microcrystalline glass of Example 2.

FIG. 2 is a transmittance curve of the microcrystalline glass of Example 2 at 360 nm-740 nm waveband.

FIG. 3 is a comparison diagram of XRD patterns of the microcrystalline glass of Example 2 before and after chemical strengthening.

FIG. 4 is a physical image of the microcrystalline glass of Example 2.

FIG. 5 is a physical image of microcrystalline glass of Example 7.

FIG. 6 is a physical image of microcrystalline glass of Comparative Example 5.

FIG. 7 is a physical image of microcrystalline glass of Comparative Example 6.

FIG. 8 is a physical image of microcrystalline glass of Comparative Example 8.

FIG. 9 is a structural schematic view of a front side of an electronic device provided by embodiments of the present invention.

FIG. 10 is a rear structural schematic view of the electronic device provided by embodiments of the present invention.

FIG. 11 shows structural schematic views of the electronic device provided by embodiments of the present invention.

Reference signs: 1-casing; 11-display screen cover plate; 12-rear housing; 13-camera protection cover plate; 2-camera assembly; 3-mid-frame; 4-display module.

## DETAILED DESCRIPTION OF EMBODIMENTS

Embodiments of the present invention will be described in detail below in conjunction with examples, while those skilled in the art would understand that the following examples are merely used for illustrating the present invention, but should not be considered as limitation to the scope of the present invention. Examples, for which concrete conditions are not specified, are carried out according to conventional conditions or conditions recommended by manufactures. If manufacturers of reagents or apparatuses used are not specified, all of them are conventional products commercially available.

Endpoints and any value of ranges disclosed herein are not limited to precise ranges or values, and these ranges or values should be understood as encompassing values close to these ranges or values. For numerical ranges, endpoint values of various ranges can be combined with each other, endpoint values of various ranges and individual point values can be combined with each other, and individual point values can be combined with each other to obtain one or more new numerical ranges, which should be construed as being specifically disclosed herein. Herein, the terms "optional" and "optionally" both mean possibly including or not (or possibly being present or not). As used herein, "and/or" is inclusive, for example, "A and/or B" means only A, or only B, or both A and B.

## Illustration of Terms and Testing Methods:

In the present invention, microcrystalline glass is a class of solid composite materials that include both a glass phase and a crystalline phase (or also known as a microcrystalline phase or a crystallization phase). Microcrystalline glass is also called as glass-ceramic or crystallized glass.

In the present invention, chemically strengthened microcrystalline glass refers to a solid composite material obtained after a chemical strengthening treatment of microcrystalline glass. It should be understood that during the chemical strengthening treatment, alkali metal ions with larger ionic radii (such as potassium ions or sodium ions) in a molten salt bath (or also known as fused salt bath) will substitute alkali metal ions with smaller ionic radii (such as sodium ions or lithium ions) in the microcrystalline glass, thereby generating an ion exchange volume difference and generating compressive stress (or also known as compression stress) on a surface of the microcrystalline glass.

In the present invention, substrate glass refers to glass which has not been subjected to nucleation treatment, crystallization treatment and strengthening treatment, or is also known as base glass.

In the present invention, composition at a center of the chemically strengthened microcrystalline glass refers to composition at or near a center of depth or thickness of the chemically strengthened microcrystalline glass, that is, composition of a region of the chemically strengthened microcrystalline glass that has not been subjected to ion exchange. It should be understood that the composition at the center of the chemically strengthened microcrystalline glass is identical or substantially identical to that of microcrystalline glass used for producing the chemically strengthened microcrystalline glass but not yet subjected to the chemical strengthening treatment.

**EP 4 674 822 A1**

In the present invention, a visible light wavelength range refers to 360 nm-740 nm.

In the present invention, haze is a percentage of transmitted light intensity that deviates from incident light by 2.5° or more relative to total transmitted light intensity.

In the present invention, a predominant crystalline phase (or also known as a principal crystalline phase) refers to a crystalline phase having a higher weight content (or also known as a weight percentage, mass percentage) than other crystalline phases present in microcrystalline glass.

In the present invention, a main surface refers to a surface with the largest surface area in a glass brick or a glass sheet, such as an upper surface or a lower surface of a horizontally disposed microcrystalline glass sheet.

In the present invention, crystallinity refers to a percentage of a total mass of crystalline phases or crystals in microcrystalline glass relative to a mass of microcrystalline glass, or is also known as a total crystalline phase content in microcrystalline glass.

In the present invention, light of a certain wavelength irradiated onto a main surface of microcrystalline glass will be reflected, absorbed and transmitted, where a ratio of intensity of a transmitted part to intensity of incident light is transmittance.

In the present invention, D65 light source is a light source with a color temperature of 6,500 K and a color rendering index Ra higher than 90, used for measuring object colors under daylight including an ultraviolet region, exhibiting broad spectral distribution in a visible wavelength region.

In the present invention, a crystallized glass precursor refers to a glass precursor that reaches certain crystallinity upon a period of heat treatment, but has not yet reached target crystallinity, and can undergo further crystallization upon heating to reach the target crystallinity.

In the present invention, CT_LD refers to tensile stress linear density, in MPa/mm. It should be understood that after the microcrystalline glass is subjected to ion exchange in a molten salt bath, a compression stress layer (or also known as a compressive stress layer) will be formed on a surface of the microcrystalline glass, and a tensile stress layer (or also known as a tension stress layer) will be formed inside the microcrystalline glass. Exemplarily, during the chemical strengthening treatment, alkali metal ions with large radii in the molten salt bath perform ion exchange with alkali metal ions with small radii in the microcrystalline glass, thereby forming the compression stress layer on the surface of the microcrystalline glass, and forming the tensile stress layer inside the microcrystalline glass, that is, obtaining chemically strengthened microcrystalline glass including the compression stress layer and the tensile stress layer. In the present invention, CT_LD is calculated through the following equation:

$$CT\_LD \ = \ |CT\_AV| \times \frac{(1000 \times t - 2 \times DOL\_0)}{t}$$

Herein, t is a thickness of the chemically strengthened microcrystalline glass, in mm; DOL_0 is a depth of the compression stress layer of the chemically strengthened microcrystalline glass, in $\mu$m; and |CT_AV| is an absolute value of an average tensile stress of the chemically strengthened microcrystalline glass, in MPa. It should be understood that in the calculation equation of the tensile stress linear density, data are put according to the above unit requirements to perform calculation, and a calculation result is obtained, where the units are not involved in the calculation.

In the present invention, CS_50 refers to a compressive stress value, in MPa, at a depth of 50 $\mu$m from the main surface of the chemically strengthened microcrystalline glass, tested by an SLP-2000 stressmeter.

In the present invention, |CT_AV| refers to an absolute value of an average tensile stress, in MPa, specifically referring to an absolute value of an average value of all tensile stresses in the tensile stress layer, tested by the SLP-2000 stressmeter.

In the present invention, |CT_CV| refers to an absolute value of a maximum tensile stress, in MPa, specifically referring to an absolute value of a maximum value of all tensile stresses in the tensile stress layer, tested by the SLP-2000 stressmeter.

In the present invention, DOL_0 refers to the depth of the compression stress layer, or is known as the depth of the compressive stress layer, specifically referring to a distance from any main surface of the chemically strengthened microcrystalline glass to a position near the surface where the compressive stress is zero, tested by the SLP-2000 stressmeter.

In the present invention, a method for testing the preceding stress performances is specifically as follows: testing |CT_CV|, DOL_0, and |CT_AV| of the chemically strengthened microcrystalline glass using the SLP 2000 stressmeter. Relevant parameters of the stressmeter are set as follows: a light source wavelength is 518 nm, SOC (stress-optic coefficient) is set to be 26 [(nm/cm)/MPa], a refractive index is set to be 1.56, and exposure time is 300 $\mu$sec. Then, a value of the tensile stress linear density (CT_LD) of the chemically strengthened microcrystalline glass is calculated through the preceding calculation equation of the tensile stress linear density.

In the present invention, b value is a yellow-blue value for characterizing a material. The b value in the present invention is a b value of transmitted light, and a positive b value indicates that the material is bluish.

In the present invention, Vickers hardness refers to a standard proposed by Robert L. Smith and George E. Sandland from Vickers Ltd. in 1921 from the UK to represent the hardness of materials.

In the present invention, the Vickers hardness is specifically tested by a method as follows: fabricating small sheets with a length, width and thickness of 50 mm × 50 mm × 0.70 mm from microcrystalline glass or chemically strengthened microcrystalline glass, selecting glass sample sheets with a clean surface and without damages visible to naked eyes, such as scratches, pits and cracks as test specimens, and then measuring the Vickers hardness thereof using a Vickers hardness tester. The Vickers hardness tester used for testing in the present invention is a digital display small-load Vickers hardness tester with model VTD405 from Beijing Kewei Technology Co., Ltd. Testing conditions are as follows: a load of 300 gf, a load time of 10 s, and validity of indentation complies with GB/T 37900-2019 Test method of hardness and fracture toughness for ultra-thin glass-Low-load Vickers hardness indentation method. Three different positions on a surface of the same test specimen are selected for measurement, and an average of three measurement results is taken as a result of the Vickers hardness of the test specimen.

In the present invention, the Young's modulus is used for characterizing ability of glass to undergo elastic deformation due to resistance to external force. A UMS-100 ultrasonic material characterization system is used in the present invention for measuring the Young's modulus of the microcrystalline glass.

In the present invention, nucleation treatment refers to growth of a nucleating material in substrate glass into small crystal nucleuses through heat treatment; and crystallization treatment refers to growth of a certain type of crystals on the basis of the crystal nucleuses through heat treatment.

In the present invention, the thickness of the microcrystalline glass is obtained by micrometer measurement. It should be understood that along a thickness direction, a degree of ion exchange gradiently varies from a surface to a center, while an overall exchange capacity increment (mass) of Na-K and/or Li-Na generally is less than 1.5% of the total mass of the sample. Thus, a swelling effect along the thickness direction is extremely slight, and it can be approximately considered that the thickness is substantially unchanged. That is, before and after the chemical strengthening, the thickness change of the microcrystalline glass is quite small and substantially negligible, and the thickness of the microcrystalline glass is substantially the same as that of the chemically strengthened microcrystalline glass produced therefrom.

In the present invention, a size specification of a microcrystalline glass sheet is tested by a quadratic measuring instrument (instrument model: Miyu MY-YXCL-4030).

In the present invention, crystalline phases, crystallinity and an average grain size of the microcrystalline glass or the chemically strengthened microcrystalline glass are identified through XRD test. Specifically:

(1) XRD test: the microcrystalline glass or the chemically strengthened microcrystalline glass of the present invention are ground into a sample with a particle size of less than 75 μm, and the sample obtained from grinding is tested using an X-ray diffractometer, so as to obtain an XRD diffraction peak curve and XRD diffraction data. X-ray diffractometer used in the present invention is Shimadzu XRD-6100, a target material is copper, $2\theta$=10°-50°, a scanning speed is 6°/min, an operating voltage is 40 kV, and an operating current is 30 mA.

(2) Determination of the crystalline phases: the XRD diffraction data are analyzed using Jade software (JADE Standard 8.6), so as to determine the crystalline phases in the sample.

(3) Determination of the crystallinity (or also known as the total crystalline phase content): a test result (RAW format) of XRD is imported into X-ray diffraction data Rietveld refinement software Jade for fitting and calculation, so as to determine the crystallinity of the sample. Specifically, a ratio of the fitted crystalline phase peak area to a fitted total peak area is recorded as the crystallinity of the sample.

(4) Determination of the average grain size (or also known as average crystal size): using the result data obtained from the XRD test, the average grain size of the sample can be calculated according to Scherrer equation $D=K\lambda/(\beta cos\theta)$. Herein, $\lambda$ is an X-ray wavelength, $\lambda$=0.154056 nm, $\beta$ is full width at half maximum of the diffraction peak, K=0.89, and $\theta$ is a Bragg diffraction angle. Specifically, the RAW file output from XRD instrument is curve-fitted in Jade software, and a fitting report is output by Jade. Based on the angle $2\theta$ value and Peak FWHM value corresponding to each diffraction peak in the fitting report, the Peak FWHM value is converted to the radian system: $\beta$=(FWHM/180×3.14), and through the Scherrer equation $D=K\lambda/(\beta cos\theta)$, the grain size of each diffraction peak is calculated and then averaged, so as to obtain the average grain size of the sample.

In the present invention, the transmittance, haze and b value of the microcrystalline glass of the present invention are tested using a haze meter with reference to the national standard "GB/T 7962.12-2010 Test methods of colorless optical glass - Part 12: Spectral internal transmittance". Specifically, the haze meter is utilized to test the transmittance, haze and b value of five pieces of microcrystalline glass in the same batch at light with different wavelengths. Average values of the b value and haze measured for the five pieces of microcrystalline glass are respectively recorded as the b value result and the haze result of the microcrystalline glass. An average value of the transmittance of the five pieces of microcrystalline glass at light with a wavelength of 550 nm is taken and recorded as a transmittance result of the microcrystalline glass at light with the wavelength of 550 nm. The haze meter used for testing in the present invention is a spectrophotometer CM-3600A from Japanese Konica Minolta, a light receiving optical system is transmission, a spectroscopic method is plane reflective grating, a wavelength ranges from 360 nm to 740 nm, a wavelength spacing is 10 nm, an illumination light source is pulsed xenon lamp ×4, an ambient temperature where the instrument is placed is 24 °C, and air humidity is 40%.

In the present invention, among a plurality of chemically strengthened microcrystalline glass samples in the same embodiment or the same comparative example, a value obtained by dividing a sum of measured anti-sandpaper drop heights of each sample by the number of samples measured is recorded as an average anti-sandpaper drop height of the tested chemically strengthened microcrystalline glass, which is used for characterizing drop damage resistance performance of the chemically strengthened microcrystalline glass. Specifically, at least 10 samples are taken from each batch for testing, and the average anti-sandpaper drop height is $\langle h \rangle n = \dfrac{1}{n} \sum_{i=1}^{n} hi$ , where n is the number of glass samples tested in each batch, and *hi* is the anti-sandpaper drop height tested for a single sample.

Herein, a testing method for the anti-sandpaper drop height of a single sample includes following steps:

step 1: attaching 80-mesh sandpaper to a lower surface of a 181g model machine, and placing the model machine on a LVTU LT-SKDL-CD type drop tester;

step 2: placing a chemically strengthened microcrystalline glass sample to be tested directly below the model machine, with the chemically strengthened microcrystalline glass sample facing the sandpaper, specifically a main surface of the chemically strengthened microcrystalline glass facing the sandpaper; dropping the model machine from a certain height to impact the chemically strengthened microcrystalline glass sample directly below the model machine; increasing the drop height of the model machine according to a certain pattern, if the chemically strengthened microcrystalline glass sample does not break, and further dropping the model machine to impact the chemically strengthened microcrystalline glass sample located directly below the model machine, until the chemically strengthened microcrystalline glass sample breaks. For example, starting with a drop height of 0.4 m of the model machine, a drop impact is performed on the sample, and if the sample does not break, the drop height of the model machine is increased by 0.1 m so as to perform the drop again, and the preceding process is repeated until the chemically strengthened microcrystalline glass sample breaks; and

step 3: recording the last drop height before the chemically strengthened microcrystalline glass sample broke as the anti-sandpaper drop height thereof. For instance, if the drop height is increased by 0.1 m each time, when the sample breaks at a drop height of 0.5 m, the anti-sandpaper drop height of the sample is 0.4 m.

Without being bound by any theory, it is presumed that when the microcrystalline glass is subjected to a chemical strengthening treatment, it is mainly the alkali metal ions in the glass phase that are subjected to ion exchange with the alkali metal ions in the molten salt bath, so that a compression stress structure is formed on the surface of the microcrystalline glass, thereby further improving mechanical strength and damage resistance performance of the microcrystalline glass. Although a dense grain structure included in the microcrystalline glass is beneficial to improve intrinsic strength (or also known as inherent strength) of the microcrystalline glass, and improve the damage resistance performance of the microcrystalline glass, connection structures formed by dense grains in the microcrystalline glass will enclose the glass phase (or also known as residual glass phase) between the grains, which will hinder paths of the ion exchange, thereby impeding the ion exchange of the alkali metal ions in the glass phase with the alkali metal ions in the molten salt bath for chemical strengthening, thus increasing the difficulty of obtaining high stress performance by chemically strengthening the microcrystalline glass, that is, increasing the fabrication difficulty of the high-strength chemically strengthened microcrystalline glass. Particularly, a lithium aluminosilicate glass system tends to precipitate multiple crystalline phases after the heat treatment, and crystalline phases potentially precipitated include a lithium disilicate crystalline phase, a quartz crystalline phase or a lithium metasilicate crystalline phase, etc., microcrystalline glass with multiple crystalline phases tends to have higher crystallinity, and the higher the crystal content, the more the energy and time required for ion diffusion, that is, the structure with multiple crystalline phases may further increase the difficulty of ion exchange of the microcrystalline glass.

In the prior art, in order to produce chemically strengthened microcrystalline glass that meet application requirements, it is a typical practice to subject existing microcrystalline glass to a prolonged chemical strengthening treatment, or to perform a chemical strengthening treatment on the microcrystalline glass using a high-temperature (for example, exceeding 480 °C) molten salt bath. Both prolonging the strengthening time and elevating the molten salt bath temperature will lead to increased chemical strengthening costs of microcrystalline glass, and raising production costs of high-strength chemically strengthened microcrystalline glass.

In view of this, in order to improve economic effectiveness, the present invention provides a microcrystalline glass that is distinct from the prior art, has excellent optical properties and high intrinsic strength, and can achieve rapid ion exchange so as to obtain a high stress level. The microcrystalline glass of the present invention enables rapid and efficient production of chemically strengthened microcrystalline glass having a high stress level, excellent mechanical strength performance, and superior damage resistance performance under conventional chemical strengthening process conditions.

As stated above, some embodiments of the present invention provide a microcrystalline glass, where the microcrystalline glass includes a lithium disilicate crystalline phase ($Li_2Si_2O_5$), where the lithium disilicate crystalline phase accounts for a higher weight percentage than other crystalline phases present in the microcrystalline glass. In terms of molar percentage of oxides, the microcrystalline glass includes following components: $SiO_2$: 61.50%-63.40%, $Al_2O_3$: 2.75%-2.99%, $P_2O_5$: 0.91%-1.91%, $ZrO_2$: 4.20%-4.85%, $Na_2O$: 1.85%-3.20%, $B_2O_3$: 0-1.00% and $Li_2O$: 25.32%-26.52%.

Moreover, in the composition of the microcrystalline glass, the molar percentage $[Na_2O]$ of $Na_2O$, the molar percentage $[B_2O_3]$ of $B_2O_3$ and the molar percentage $[ZrO_2]$ of $ZrO_2$ satisfy the following relationship:

$Z=-1.344\times(2.65-100\times[Na_2O])^2+0.466\times100\times[B_2O_3]+1.203\times100\times[ZrO_2]$, where $4.80\leq Z\leq5.35$, preferably, $4.98\leq Z\leq5.20$.

The lithium disilicate ($Li_2Si_2O_5$) crystalline phase is an orthorhombic crystal based on a $[Si_2O_5]$ tetrahedral array, with the crystal being flat or plate-shaped. In the interior of the microcrystalline glass, lithium disilicate crystals are randomly oriented interlocking microstructures, which force paths of cracks to twist when passing through the crystals, thereby preventing crack propagation, and improving strength and fracture toughness of the microcrystalline glass. Moreover, the lithium disilicate crystals has a light refraction coefficient close to that of glass matrix (e.g., substrate glass for producing the microcrystalline glass in the present invention), making them an ideal crystalline phase for producing highly transparent microcrystalline glass. In the present invention, the microcrystalline glass includes structures with lithium disilicate as a predominant crystalline phase, facilitating ensuring high intrinsic strength (or also known as inherent strength) and excellent optical properties.

In the present invention, by controlling the specific composition and crystalline phase structure of the microcrystalline glass, specific ranges of contents of various components of the microcrystalline glass and the proportioning relationship between the contents of various components, specific molar percentage relationships between $Na_2O$, $B_2O_3$, $ZrO_2$ or $Li_2O$, and lithium disilicate as the predominant crystalline phase of the microcrystalline glass at the same time, the microcrystalline glass not only can be endowed with excellent optical properties and high intrinsic strength, but also the microcrystalline glass is enabled to achieve rapid and efficient production of the chemically strengthened microcrystalline glass having a high stress level and high mechanical strength performance under conventional chemical strengthening process conditions, thereby being capable of effectively reducing production costs of the high-strength chemically strengthened microcrystalline glass.

The microcrystalline glass of the present invention can be fabricated from substrate glass through heat treatment, and the composition of the substrate glass used is identical or substantially identical to that of the microcrystalline glass in terms of molar percentage of oxides.

In the present invention, $SiO_2$ is an essential component for forming a glass network structure, and is also one of the main components for forming lithium disilicate crystals. The higher the content of $SiO_2$, the denser the network structure of the glass phase, and accordingly, the higher the mechanical strength of the microcrystalline glass, the smaller the thermal expansion coefficient, and the better the heat resistance, dielectric property and chemical stability. However, if the content of $SiO_2$ is too high, a melting temperature of the substrate glass will be high, and melt viscosity will be high, thereby increasing the difficulty of forming the substrate glass. Therefore, in order to take into account both formability and various excellent properties of the glass, the molar percentage of $SiO_2$ in the substrate glass or the microcrystalline glass in the present invention is 61.50%-63.40%, preferably 61.50%-63.30%, and more preferably 62.00%-62.60%.

In some embodiments of the present invention, in terms of molar percentage of oxides, the content of $SiO_2$ in the substrate glass or the microcrystalline glass may be 62.87%, 62.88%, 63.25%, 63.26%, 62.38%, 62.27%, 62.44%, 62.45%, 62.22%, 63.17%, 61.50%, 61.60%, 61.70%, 61.80%, 61.90%, 62.00%, 62.10%, 62.20%, 62.30%, 62.40%, 62.50%, 62.60%, 62.70%, 62.80%, 62.90%, 63.00%, 63.10%, 63.20%, 63.30% or 63.40%, or may be a numerical value within a numerical range constituted by any two specific numerical values in the above as endpoints, as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

In the present invention, $Al_2O_3$ is a component forming a glass network structure, and an appropriate amount of $Al_2O_3$ is beneficial to optimize the chemical strengthening effect of the microcrystalline glass, and promote ion exchange in a chemical strengthening process to a certain extent. However, excessive $Al_2O_3$ will increase glass viscosity, and tend to precipitate other crystalline phases, such as petalite, thus affecting the crystalline phase structure of the microcrystalline glass. Therefore, in order to obtain a desired crystalline phase structure while optimizing the chemical strengthening effect of the microcrystalline glass, the molar percentage of $Al_2O_3$ in the substrate glass or the microcrystalline glass is 2.75%-2.99% in the present invention.

In some embodiments of the present invention, in terms of molar percentage of oxides, a content of $Al_2O_3$ in the substrate glass or the microcrystalline glass may be 2.75%, 2.77%, 2.79%, 2.81%, 2.83%, 2.85%, 2.86%, 2.87%, 2.89%, 2.91%, 2.93%, 2.94%, 2.95%, 2.97% or 2.99%, or may be a numerical value within a numerical range constituted by any two specific numerical values in the above as endpoints, as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

In the present invention, $P_2O_5$ acts as a nucleating agent, and has an effect of promoting uniform nucleation of glass. Both too low and too high content thereof will lead to a poor crystallization effect, affect optical properties of the obtained microcrystalline glass, and reduce transparency of the microcrystalline glass. Therefore, in order to obtain a desired crystalline phase structure and further achieve excellent optical properties and superior mechanical strength performance, the molar percentage of $P_2O_5$ in the substrate glass or the microcrystalline glass in the present invention is 0.91%-1.91%, preferably 1.20%-1.91%, and more preferably 1.30%-1.60%.

In some embodiments of the present invention, in terms of molar percentage of oxides, a content of $P_2O_5$ in the substrate glass or the microcrystalline glass may be 0.91%, 0.95%, 1.00%, 1.05%, 1.10%, 1.15%, 1.20%, 1.25%, 1.30%, 1.35%, 1.40%, 1.45%, 1.50%, 1.55%, 1.60%, 1.65%, 1.70%, 1.75%, 1.80%, 1.85%, 1.41%, 1.53%, 1.54% or 1.91%, or may be a numerical value within a numerical range constituted by any two specific numerical values in the above as endpoints, as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

In the present invention, $ZrO_2$ is an intermediate oxide in glass formation, and an appropriate amount of $ZrO_2$ can improve chemical stability of the microcrystalline glass, enhance hardness of the microcrystalline glass and scratch resistance and drop resistance capability of the microcrystalline glass. Moreover, $ZrO_2$ is also typically used as a nucleating agent in the microcrystalline glass as it has a relatively great aggregation effect due to high cationic charge and strong field intensity. However, a too high $ZrO_2$ content will cause phase separation of glass or be detrimental to obtaining microcrystalline glass with excellent optical properties. Therefore, in order to obtain microcrystalline glass having excellent optical properties and high mechanical strength, the molar percentage of $ZrO_2$ in the substrate glass or the microcrystalline glass in the present invention is 4.20%-4.85%, preferably 4.20%-4.80%.

In some embodiments of the present invention, in terms of molar percentage of oxides, a content of $ZrO_2$ in the substrate glass or the microcrystalline glass may be 4.20%, 4.35%, 4.40%, 4.45%, 4.50%, 4.55%, 4.60%, 4.65%, 4.70%, 4.75%, 4.74%, 4.84%, 4.33%, 4.34%, 4.85% or 4.80%, or may be a numerical value within a numerical range constituted by any two specific numerical values in the above as endpoints, as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

In the present invention, $Na_2O$ is a network-modifying oxide, and an appropriate amount of $Na_2O$ can provide free oxygen, which optimizes the viscosity of glass, promotes melting and clarification of a glass melt, and can also regulate a chemical strengthening rate at the same time. However, excessive $Na_2O$ will not only reduce the crystallinity of microcrystalline glass, but also affect the chemical strengthening effect of the microcrystalline glass. Therefore, in order to optimize the formability of the substrate glass and the chemical strengthening effect of the microcrystalline glass, the molar percentage of $Na_2O$ in the substrate glass or the microcrystalline glass in the present invention is 1.80%-3.20%, preferably 1.85%-3.05%, and more preferably 2.20%-3.00%.

In some embodiments of the present invention, in terms of molar percentage of oxides, a content of $Na_2O$ in the substrate glass or the microcrystalline glass may be 1.80%, 1.85%, 1.90%, 1.95%, 2.00%, 2.05%, 2.10%, 2.15%, 2.20%, 2.25%, 2.30%, 2.35%, 2.40%, 2.45%, 2.50%, 2.55%, 2.60%, 2.65%, 2.70%, 2.75%, 2.80%, 2.85%, 2.90%, 2.95%, 3.00%, 3.20%, 2.36%, 2.96%, 3.01%, 2.93% or 3.05%, or may be a numerical value within a numerical range constituted by any two specific numerical values in the above as endpoints, as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

In the present invention, $B_2O_3$ acts as a fluxing agent, and can reduce high-temperature viscosity of the glass, alleviate the problem of melting difficulty caused by $ZrO_2$, and reduce a sag temperature of the glass at the same time. However, excessive $B_2O_3$ tends to decrease transparency of the microcrystalline glass. Therefore, in order to optimize the formability of the substrate glass while obtaining microcrystalline glass with desired performance, the molar percentage of $B_2O_3$ in the substrate glass or the microcrystalline glass in the present invention is 0-1.00%, preferably 0-0.65%.

In some embodiments of the present invention, in terms of molar percentage of oxides, a content of $B_2O_3$ in the substrate glass or the microcrystalline glass may be 0, 0.05%, 0.10%, 0.15%, 0.20%, 0.25%, 0.30%, 0.35%, 0.40%, 0.45%, 0.50%, 0.55%, 0.65%, 0.70%, 0.80%, 0.90%, 1.00% or 0.60%, or may be a numerical value within a numerical range constituted by any two specific numerical values in the above as endpoints, as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

In the present invention, $Li_2O$ is an essential component for forming the predominant crystalline phase lithium disilicate, and is also an essential component for providing lithium ions for ion exchange in a chemical strengthening process. An appropriate amount of $Li_2O$ not only facilitates optimizing the viscosity of the glass and promoting the melting and clarification of the glass melt, but also facilitates ensuring a desired content of lithium disilicate crystals. Moreover, $Li_2O$ can also provide alkali metal lithium ions for ion exchange with ions with large radii (e.g., sodium ions) in the molten salt bath, which is a critical factor affecting an attainable stress level of the chemically strengthened microcrystalline glass. However, excessive $Li_2O$ will deteriorate the optical properties of the microcrystalline glass. Therefore, in order to optimize the formability of the substrate glass and obtain the microcrystalline glass with desired performance while optimizing the chemical strengthening effect of the microcrystalline glass, the molar percentage of $Li_2O$ in the substrate glass or the microcrystalline glass in the present invention is 25.32%-26.52%, preferably 25.52%-26.52%, and more preferably 25.52%-26.00%.

In some embodiments of the present invention, in terms of molar percentage of oxides, a content of $Li_2O$ in the substrate glass or the microcrystalline glass may be 25.32%, 25.52%, 25.60%, 25.65%, 25.70%, 25.75%, 25.80%, 25.85%, 25.90%, 25.95%, 26.00%, 26.05%, 26.10%, 26.15%, 26.20%, 26.25%, 26.30%, 26.35%, 26.40%, 26.45%, 25.62%, 25.82%, 25.69%, 25.36%, 25.77%, 25.87%, 25.79%, 26.03%, 25.74% or 26.52%, or may be a numerical value within a numerical range constituted by any two specific numerical values in the above as endpoints, as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

In the present invention, on the basis of adjusting and controlling content ranges of various oxide components, by adjusting and controlling proportioning relationships between various oxide components, particularly the molar percentage relationships between $Na_2O$, $B_2O_3$, $ZrO_2$ or $Li_2O$, it is not only beneficial to ensure that the microcrystalline glass with a desired crystalline phase structure is obtained, and that the microcrystalline glass achieves excellent optical properties and high intrinsic strength, and but also conducive to ensuring that the obtained microcrystalline glass achieves a better chemical strengthening effect, so that the microcrystalline glass enables rapid and efficient production of the chemically strengthened microcrystalline glass having a high stress level and high mechanical strength performance under conventional chemical strengthening process conditions, thereby being capable of effectively reducing production costs of the high-strength chemically strengthened microcrystalline glass.

In some embodiments of the present invention, in the composition of the substrate glass or the microcrystalline glass, a value of the molar percentage relationship Z between $Na_2O$, $B_2O_3$ and $ZrO_2$ may be 4.80, 4.85, 4.90, 4.95, 4.98, 5.05, 5.06, 5.07, 5.08, 5.09, 5.10, 5.11, 5.12, 5.13, 5.14, 5.15, 5.16, 5.17, 5.18, 5.19, 5.35, 5.30 or 5.20, or may be a numerical value within a numerical range constituted by any two specific numerical values in the above as endpoints, as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

In some embodiments of the present invention, in the composition of the substrate glass or the microcrystalline glass, the molar percentage $[Na_2O]$ of $Na_2O$ and the molar percentage $[B_2O_3]$ of $B_2O_3$ satisfy the following relationship: $0.90\% \leq [Na_2O]-[B_2O_3] \leq 3.10\%$, preferably $1.25\% \leq [Na_2O]-[B_2O_3] \leq 3.02\%$, and more preferably $2.00\% \leq [Na_2O]-[B_2O_3] \leq 3.00\%$.

In some embodiments, in the composition of the substrate glass or the microcrystalline glass, a difference, $[Na_2O]-[B_2O_3]$, in molar percentage between $Na_2O$ and $B_2O_3$ may be 0.90%, 1.00%, 1.20%, 1.25%, 1.26%, 1.35%, 1.45%, 1.55%, 1.65%, 1.75%, 1.85%, 1.95%, 2.00%, 2.05%, 2.15%, 2.25%, 2.35%, 2.45%, 2.50%, 2.55%, 2.65%, 2.75%, 2.85%, 2.95%, 3.10%, 1.79%, 0.96%, 2.36%, 2.96%, 3.01%, 2.93%, 3.00% or 3.02%, or may be a numerical value within a numerical range constituted by any two specific numerical values in the above as endpoints, as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

In some embodiments of the present invention, in the composition of the substrate glass or the microcrystalline glass, the molar percentage $[Na_2O]$ of $Na_2O$ and the molar percentage $[Li_2O]$ of $Li_2O$ satisfy the following relationship: $8.55 \leq [Li_2O]/[Na_2O] \leq 13.85$, preferably $8.55 \leq [Li_2O]/[Na_2O] \leq 11.50$.

In some embodiments, in the composition of the substrate glass or the microcrystalline glass, a ratio, $[Li_2O]/[Na_2O]$, of the molar percentages of $Li_2O$ and $Na_2O$ may be 8.55, 9.00, 9.50, 10.00, 10.50, 10.55, 11.00, 11.50, 12.00, 12.50, 13.00, 13.50, 13.83, 10.93, 13.01, 10.92, 8.73, 8.61, 8.79, 8.83 or 13.85, or may be a numerical value within a numerical range constituted by any two specific numerical values in the above as endpoints, as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

In some embodiments of the present invention, on the basis of the above composition ranges, the composition of the substrate glass or the microcrystalline glass can further include other components, as long as the microcrystalline glass or the chemically strengthened microcrystalline glass with desired performance in the present invention can be obtained. For example, in some embodiments, the composition of the substrate glass or the microcrystalline glass can further include: CaO: 0.00 mol%-1.00 mol% and $K_2O$: 0.00 mol%-1.00 mol%, in terms of molar percentage of oxides.

In the present invention, "the lithium disilicate crystalline phase has a higher weight percentage than other crystalline phases present in the microcrystalline glass" or "lithium disilicate is taken as the predominant crystalline phase" or other similar expressions mean that the lithium disilicate crystalline phase accounts for more than 70 weight percent (weight%) of all crystalline phases of the microcrystalline glass according to embodiments of the present invention. In some embodiments, the lithium disilicate crystalline phase accounts for 70% or more by weight of all the crystalline phases of the microcrystalline glass, and preferably, the lithium disilicate crystalline phase accounts for 85% or more by weight of all the crystalline phases of the microcrystalline glass. Exemplarily, in all crystalline phases of the microcrystalline glass, the lithium disilicate crystalline phase may account for 70%, 79%, 80%, 81%, 82%, 83%, 84%, 85%, 86%, 87%, 88%, 89%, 90%, 91%, 92%, 93%, 94%, 96%, 97%, 98%, 100% or 95% by weight, or a numerical value within a numerical range constituted by any two specific numerical values in the above as endpoints, as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

In some embodiments of the present invention, the crystallinity of the microcrystalline glass is not lower than 45%, preferably, the crystallinity of the microcrystalline glass is 45%-85%, and more preferably, the crystallinity of the microcrystalline glass is 55%-65%. Higher crystallinity of the microcrystalline glass facilitates the microcrystalline glass in obtaining high impact resistance and high intrinsic strength. However, too high crystallinity will affect the chemical strengthening effect of the microcrystalline glass, prolong the chemical strengthening time for obtaining the chemically strengthened microcrystalline glass with a high stress level, and affect the optical properties of the microcrystalline glass. In the present invention, by enabling the microcrystalline glass to satisfy the desired crystallinity, it is beneficial to ensure the microcrystalline glass to have excellent optical properties while optimizing the chemical strengthening effect thereof in cases where the microcrystalline glass has good impact resistance and high intrinsic strength.

In some embodiments of the present invention, the crystallinity of the microcrystalline glass may be 45%, 50%, 55%, 60%, 65%, 70%, 75%, 80% or 85%, or may be a numerical value within a numerical range constituted by any two specific numerical values in the above as endpoints, as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

In some embodiments of the present invention, non-limiting examples of other potential crystalline phases in the microcrystalline glass include: a petalite crystalline phase, and/or a lithium phosphate crystalline phase. In some embodiments, the microcrystalline glass further includes the petalite crystalline phase. Preferably, the petalite crystalline phase accounts for $\leq 20\%$ by weight of the microcrystalline glass, and more preferably, the petalite crystalline phase accounts for $\leq 15\%$, $\leq 10\%$, or $\leq 5\%$ by weight of the microcrystalline glass. In some embodiments, the microcrystalline glass preferably is free of the petalite crystalline phase. By controlling precipitation of other crystalline phases, it is more beneficial to ensure that lithium disilicate forms desired interlocking structures, thereby ensuring high mechanical strength performance, excellent optical properties and excellent damage resistance performance of the microcrystalline glass.

In some embodiments of the present invention, in the microcrystalline glass, the average grain size is not larger than 100 nm; preferably, the average grain size is not larger than 40 nm; and more preferably, the average grain size is 15-30 nm. A suitable average grain size is beneficial to enable the microcrystalline glass to have both excellent optical properties and high intrinsic strength, and if the average grain size is too large, the microcrystalline glass tends to devitrify, and the chemical strengthening effect will also be affected. In the present invention, by enabling the microcrystalline glass to satisfy an appropriate average grain size, it is beneficial to ensure the microcrystalline glass to have excellent optical properties while optimizing the chemical strengthening effect thereof in cases where the microcrystalline glass has good impact resistance and high intrinsic strength.

In some embodiments, the average grain size of the microcrystalline glass may be 100 nm, 50 nm, 40 nm, 35 nm, 30 nm, 25 nm, 20 nm, 15 nm or 10 nm, or may be a numerical value within a numerical range constituted by any two specific numerical values in the above as endpoints, as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

In some embodiments of the present invention, the microcrystalline glass is transparent within the visible light wavelength range. Preferably, at a thickness of 0.70 mm, for light with a wavelength of 550 nm, transmittance of the microcrystalline glass is ≥90.00%, and preferably the transmittance is >90.40%. The microcrystalline glass satisfying the transmittance can ensure good light transmission and good transparency, and is suitable for use in display screens requiring quality display effect. The "visible light wavelength range" herein refers to light with a wavelength of 360 nm-740 nm.

In some embodiments, at a thickness of 0.70 mm, for light with a wavelength of 550 nm, the transmittance of the microcrystalline glass may be 90.00%, 90.10%, 90.20%, 90.30%, 90.40%, 90.50%, 91.00%, 90.52%, 90.70%, 90.64%, 90.85%, 90.74%, 90.63%, 90.51% or 92.00%, or may be a numerical value within a numerical range constituted by any two specific numerical values in the above as endpoints, for example, the transmittance of the microcrystalline glass may be 90%-92% or 90.4%-92%, etc., as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

In some embodiments of the present invention, at a thickness of 0.70 mm, the haze of the microcrystalline glass is <0.30%. Haze is cloudy or hazy appearance of an interior or surface of the microcrystalline glass due to light diffusion. The smaller the haze, the better the transparency and display effects of the microcrystalline glass. In some embodiments, at a thickness of 0.70 mm, the haze of the microcrystalline glass may be 0.25%, 0.20%, 0.15%, 0.10%, 0.05%, 0.21%, 0.14%, 0.12%, 0.14%, 0.16% or 0.30%, or may be a numerical value within a numerical range constituted by any two specific numerical values in the above as endpoints, as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

In some embodiments of the present invention, at a thickness of 0.70 mm, the b value of the microcrystalline glass is <0.70, and preferably, the b value is ≤0.60. In the present invention, the b value refers to an optical b value measured under a D65 light source. In the present invention, Konica Minolta CM-3600 A is used for testing the b value in a transmittance mode, and b (D65) is displayed in the result. The smaller the b value is, the better the display effect of the microcrystalline glass can be ensured. When the b value is relatively large, undesirable colors will appear in the microcrystalline glass, causing the display effect thereof to fail to meet application requirements of the display screen cover glass.

In some embodiments, at the thickness of 0.70 mm, the b value of the microcrystalline glass may be 0.70, 0.65, 0.60, 0.55, 0.50, 0.45, 0.40, 0.35, 0.30, 0.25, 0.48, 0.47, 0.52, 0.51, 0.54 or 0.20, or may be a numerical value within a numerical range constituted by any two specific numerical values in the above as endpoints, as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

The microcrystalline glass of the present invention has a high transmittance, a relatively low haze, and a relatively low b value, which all indicate that the microcrystalline glass of the present invention has excellent optical properties, good uniformity, and a transparent state, and can satisfy the application requirements of the display screen cover glass of electronic devices.

In some embodiments of the present invention, the Young's modulus of the microcrystalline glass is ≥100 GPa, and preferably, the Young's modulus of the microcrystalline glass is 105-112.50 GPa. In the present invention, by making the Young's modulus of the microcrystalline glass not less than 100 GPa, it is beneficial to ensure the high network structural strength of the microcrystalline glass, reduce a stress relaxation effect of the microcrystalline glass during ion exchange, and slow down weakening effects of high temperature, long time and other factors in the ion exchange on deep stress in composite compressive stress.

In some embodiments, the Young's modulus of the microcrystalline glass may be 100 GPa, 105 GPa, 110 GPa, 106.32 GPa, 111.12 GPa, 110.82 GPa, 111.32 GPa, 110.91 GPa, 112.10 GPa, 111.87 GPa or 112.50 GPa, or may be a numerical value within a numerical range constituted by any two specific numerical values in the above as endpoints, as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

In some embodiments of the present invention, the Vickers hardness of the microcrystalline glass is ≥640 kgf/mm$^2$, and preferably, the Vickers hardness of the microcrystalline glass is 640-680 kgf/mm$^2$. The Vickers hardness of the microcrystalline glass within the above range indicates that the microcrystalline glass has high hardness and high intrinsic strength, thereby ensuring that it has an excellent physical property, and facilitating producing the chemically strengthened microcrystalline glass having high mechanical strength and excellent damage resistance.

In some embodiments, the Vickers hardness of the microcrystalline glass may be 640 kgf/mm$^2$, 650 kgf/mm$^2$, 660 kgf/mm$^2$, 670 kgf/mm$^2$, 660.12 kgf/mm$^2$, 654.02 kgf/mm$^2$, 650.20 kgf/mm$^2$, 652.31 kgf/mm$^2$, 659.65 kgf/mm$^2$, 651.70 kgf/mm$^2$, 654.92 kgf/mm$^2$ or 680 kgf/mm$^2$, or may be a numerical value within a numerical range constituted by any two specific numerical values in the above as endpoints, as long as the microcrystalline glass or the chemically strengthened microcrystalline glass with desired performance in the present invention can be obtained. It should be understood that in embodiments, any of the above ranges can be combined with any other ranges, as long as the microcrystalline glass or the chemically strengthened microcrystalline glass with desired performance in the present invention can be obtained.

In some embodiments, the microcrystalline glass includes planar microcrystalline glass or curved microcrystalline glass. Preferably, when the microcrystalline glass is curved microcrystalline glass, the microcrystalline glass can be fabricated by performing a 3D hot bending treatment on a crystallized glass precursor with crystallinity not lower than 5%. Without being bound by any theory, the present invention reveals that by performing the 3D hot bending on a partially crystallized crystalline glass precursor, while the glass is hot-bent and deformed, the glass undergoes further crystallization upon heating to achieve target crystallinity, thus enabling more precise control over a deformation quantity after the 3D hot bending, reducing a profile tolerance fluctuation, rendering a more stable dimension, and elevating dimensional precision of the curved microcrystalline glass after the hot bending. Those skilled in the art could determine the crystallinity of the selected partially crystallized glass precursor specifically according to the crystallinity of the desired curved microcrystalline glass. For example, when the crystallinity of the desired curved microcrystalline glass is about 60%, the partially crystallized glass precursor with crystallinity of 50% can be selected to subject to a hot bending treatment, so as to obtain the curved microcrystalline glass satisfying the target crystallinity. In the present invention, in terms of molar percentage of oxides, the composition of the partially crystallized glass is identical or substantially identical to that of the microcrystalline glass.

In some embodiments, the thickness of the microcrystalline glass is 0.10-5.00 mm. Exemplarily, the thickness of the microcrystalline glass may be 0.10-2.00 mm, 0.20-1.00 mm or 0.40-0.80 mm.

Following the preceding introduction to the composition, microstructure and other contents of the microcrystalline glass, a preparation method for the microcrystalline glass is specifically described below.

In the present invention, a preparation process of the microcrystalline glass mainly includes: a preparation process of substrate glass and a heat treatment process of the substrate glass.

In the present invention, the substrate glass can be fabricated by forming methods in the prior art, which is not limited in any way in the present invention. For example, the forming methods of the substrate glass may include but are not limited to a floating, overflowing, rolling or casting process. Exemplarily, the substrate glass can be obtained by homogenizing various components according to a formula, followed by melt-forming, cooling and annealing processes.

Exemplarily, various raw materials (conventional industrial raw materials) are formulated according to formula proportions, a fining agent is added, and then they are mixed for a period of time, so as to render a uniform raw material mixture. The raw material mixture heated in a platinum crucible to 1,250 °C-1,680 °C, preferably a melting temperature being 1,480 °C-1,680 °C, and preferably maintaining this temperature condition for 3-12 h, then poured into a forming mold for cooling and forming, preferably cooled to 750 °C-1,000 °C, and then put into an annealing furnace for an annealing treatment, an annealing temperature preferably being 400 °C-650 °C, and an annealing time preferably being 10-48 h, followed by cooling to room temperature with the furnace, so as to render the substrate glass. Those skilled in the art could choose type and amount of the fining agent according to demand, without using any inventive efforts. Further, the fining agent may include, but is not limited to, one or more of sodium chloride, tin oxide, antimony oxide, arsenic oxide, etc., and the fining agent can be added in an amount of 0-1 wt% of a total amount of various raw materials.

In some embodiments of the present invention, the heat treatment process of the substrate glass may include a nucleation treatment and/or a crystallization treatment, and preferably the nucleation treatment and the crystallization treatment are employed. In some embodiments, the crystallization treatment includes one-step crystallization treatment or two-step crystallization treatment. In some embodiments, in order to prepare the curved microcrystalline glass, the two-step crystallization treatment can be employed. When the two-step crystallization treatment is employed, a second step of the crystallization treatment includes heating a crystallized glass precursor obtained from a first step of crystallization treatment to a crystallization temperature and performing a 3D hot bending treatment, and performing a secondary crystallization in a 3D hot bending process.

In some embodiments of the present invention, in order to enable the microcrystalline glass to obtain desired physical and chemical properties, when the heat treatment is performed on the substrate glass, one-step heat treatment or two-step or multi-step heat treatment can be performed. If the one-step heat treatment is performed, the nucleating treatment (i.e. nucleation treatment) is not separately performed, instead, one-step heating is directly performed, and nucleation and crystal growth are performed in a temperature reached by the one-step heating process, which can be understood as directly performing the crystallization treatment. If the two-step heat treatment is performed, it means that two steps of heating process are performed, including, but not limited to: first performing the nucleating treatment, i.e., the nucleation treatment, and then performing a target crystal growth treatment, i.e., the crystallization treatment.

In order to enable the microcrystalline glass to precipitate desired crystalline phases and obtain desired physical and chemical properties, further, the nucleation treatment can be performed at a temperature of 530-600 °C for 0-24 h, preferably 2-8 h; the crystallization treatment can be performed at a temperature of 700-750 °C for 0.10-24 h, preferably 1-3 h. When performing the heat treatment, a heating rate is preferably controlled to be 5-15 °C/min, and more preferably the heating rate is 10 °C/min. Herein, the temperature of the nucleation treatment refers to the temperature at which nuclei can be formed. The temperature of the crystallization treatment refers to a temperature conducive to controllable growth of the target crystals.

After the heat treatment, those skilled in the art could further perform other conventional steps so as to obtain a microcrystalline glass sample meeting required specification or required requirements, for example, steps such as shaping treatment, cutting treatment (for example, using a multi-wire cutting machine for cutting), CNC machining control (computer numerical control), thinning treatment or polishing treatment can be performed.

Some embodiments of the present invention further provide a chemically strengthened microcrystalline glass. The chemically strengthened microcrystalline glass is fabricated by chemically strengthening the preceding microcrystalline glass. Composition at a center of the chemically strengthened microcrystalline glass is identical to that of the microcrystalline glass in any of the preceding embodiments. The chemically strengthened microcrystalline glass includes a compression stress layer region extending from a surface of the chemically strengthened microcrystalline glass to a compression depth, and there is a tensile stress inside the chemically strengthened microcrystalline glass, that is, the chemically strengthened microcrystalline glass includes a compression stress layer and a tensile stress layer.

The chemical strengthening treatment, i.e., an ion exchange process, is exchange of alkali metal ions with smaller ionic radii in the microcrystalline glass with alkali metal ions with larger ionic radii in the molten salt bath by immersing the microcrystalline glass in the molten salt bath, thereby forming a compressive stress layer on a surface of the microcrystalline glass so as to obtain the chemically strengthened microcrystalline glass with superior mechanical performance.

It should be understood that compared with the microcrystalline glass before the chemical strengthening, composition of a microcrystalline glass article on a surface after undergoing the chemical strengthening treatment may be different from that of as-formed microcrystalline glass (i.e., the microcrystalline glass prior to the chemical strengthening treatment, which has not undergone ion exchange). This is because that during the ion exchange, in the as-formed microcrystalline glass, one type of alkali metal ions (e.g., $Li^+$ or $Na^+$) on the surface of the microcrystalline glass will be substituted by larger alkali metal ions (e.g., $Na^+$ or $K^+$). However, in the embodiments, the glass composition and phase set at or near a center of depth of the microcrystalline glass article may still have the composition and phase set of the as-formed microcrystalline glass. That is to say, in the present invention, the composition (e.g., the composition of the tensile stress layer) and phase set at the center of the chemically strengthened microcrystalline glass having undergone the chemical strengthening treatment is identical or substantially identical to that of the as-formed microcrystalline glass.

In some embodiments of the present invention, the chemical strengthening treatment can employ a single-step strengthening process or a multi-step strengthening process. The molten salt bath for the chemical strengthening treatment is a molten salt bath containing sodium salt and/or potassium salt. Preferably, the molten salt bath for the chemical strengthening treatment in the present invention is a mixed molten salt bath containing sodium salt and potassium salt, and preferably, a temperature of the molten salt bath is 380 °C-470 °C, and more preferably, 430 °C-460 °C. In some embodiments of the present invention, a concentration of the potassium salt in the salt bath is preferably 0 wt%-90 wt%, a concentration of the sodium salt is 10 wt%-100 wt%, and more preferably, a certain amount (e.g., 0-0.2 wt%) of lithium salt is added to the salt bath. In some embodiments of the present invention, the chemical strengthening treatment preferably lasts for 0.1-3 h. Herein, the sodium salt may be at least one selected from sodium nitrate, sodium sulfate, and sodium carbonate, preferably sodium nitrate; the potassium salt may be at least one selected from potassium nitrate, potassium sulfate, and potassium carbonate, preferably potassium nitrate; and the lithium salt may be at least one selected from lithium nitrate, lithium sulfate, and lithium carbonate, preferably lithium nitrate.

In some embodiments of the present invention, the chemically strengthened microcrystalline glass includes a lithium disilicate crystalline phase, where the lithium disilicate crystalline phase accounts for a higher weight percentage than other crystalline phases present in the chemically strengthened microcrystalline glass. In terms of molar percentage of oxides, components at the center of the chemically strengthened microcrystalline glass include: $SiO_2$: 61.50%-63.40%, $Al_2O_3$: 2.75%-2.99%, $P_2O_5$: 0.91%-1.91%, $ZrO_2$: 4.20%-4.85%, $Na_2O$: 1.80%-3.20%, $B_2O_3$: 0-1.00% and $Li_2O$: 25.32%-26.52%.

Moreover, in the composition at the center of the chemically strengthened microcrystalline glass, the molar percentage $[Na_2O]$ of $Na_2O$, the molar percentage $[B_2O_3]$ of $B_2O_3$ and the molar percentage $[ZrO_2]$ of $ZrO_2$ satisfy the following relationship:

$Z=-1.344\times(2.65-100\times[Na_2O])^2+0.466\times100\times[B_2O_3]+1.203\times100\times[ZrO_2]$, $4.80\leq Z\leq5.35$, preferably, $4.98\leq Z\leq5.20$.

In some embodiments of the present invention, in the composition at the center of the chemically strengthened microcrystalline glass, the molar percentage $[Na_2O]$ of $Na_2O$ and the molar percentage $[B_2O_3]$ of $B_2O_3$ satisfy the following relationship:

$0.90\%\leq[Na_2O]-[B_2O_3]\leq3.10\%$, preferably, $1.25\%\leq[Na_2O]-[B_2O_3]\leq3.02\%$, and more preferably, $2.00\%\leq[Na_2O]-[B_2O_3]\leq3.00\%$; and/or

in the composition at the center of the chemically strengthened microcrystalline glass, the molar percentage $[Na_2O]$ of $Na_2O$ and the molar percentage $[Li_2O]$ of $Li_2O$ satisfy the following relationship:

$8.55\leq[Li_2O]/[Na_2O]\leq13.85$, and preferably, $8.55\leq[Li_2O]/[Na_2O]\leq11.50$.

In some embodiments of the present invention, the chemically strengthened microcrystalline glass has the CT_LD of 45,000-55,000 MPa/mm, where CT_LD is the tensile stress linear density, and preferably, the chemically strengthened microcrystalline glass has the CT_LD of 48,000-53,000 MPa/mm. The CT_LD of the chemically strengthened microcrystalline glass is controlled to be 45,000-55,000 MPa/mm, which is conducive to ensuring that the tensile stress stored inside the chemically strengthened microcrystalline glass is dense enough, thereby ensuring it to have a high surface stress level and excellent damage resistance performance, such as excellent drop resistance performance, so as to meet market requirements.

In some embodiments, the CT_LD of the chemically strengthened microcrystalline glass may be 45,000 MPa/mm, 46,000 MPa/mm, 47,000 MPa/mm, 48,000 MPa/mm, 49,000 MPa/mm, 50,000 MPa/mm, 51,000 MPa/mm, 52,000 MPa/mm, 53,000 MPa/mm, 54,000 MPa/mm, 50,479 MPa/mm, 50,547 MPa/mm, 50,297 MPa/mm, 50,497 MPa/mm, 50,833 MPa/mm, 52,768 MPa/mm or 55,000 MPa/mm, or may be a numerical value within a numerical range constituted by any two specific numerical values in the above as endpoints, as long as the chemically strengthened microcrystalline glass with desired performance in the present invention can be obtained. It should be understood that in embodiments, any of the above ranges can be combined with any other ranges, as long as the chemically strengthened microcrystalline glass with desired performance in the present invention can be obtained.

In some embodiments of the present invention, the chemically strengthened microcrystalline glass has the CS_50 of 150-199 MPa, preferably the CS_50 of 160-199 MPa. CS_50 refers to a compressive stress value at a depth of 50 $\mu$m from the main surface of the chemically strengthened microcrystalline glass. When a blunt or sharp object contacts the chemically strengthened microcrystalline glass, the stress structure of the surface of the chemically strengthened microcrystalline glass will preferentially offset an impact force to which it is subjected, and by enabling the chemically strengthened microcrystalline glass to have a high surface stress level, it can offset more remaining energy of drop, extrusion, impact or collision, thereby being advantageous to ensure that it has excellent damage resistance performance, such as excellent drop resistance performance.

In some embodiments, the CS_50 of the chemically strengthened microcrystalline glass may be 150 MPa, 160 MPa, 170 MPa, 180 MPa, 190 MPa, 163.97 MPa, 173.80 MPa, 168.90 MPa, 174.60 MPa, 178.20 MPa, 176.89 MPa, 179.72 MPa or 199 Mpa, or may be a numerical value within a numerical range constituted by any two specific numerical values in the above as endpoints, as long as the chemically strengthened microcrystalline glass with desired performance in the present invention can be obtained. It should be understood that in embodiments, any of the above ranges can be combined with any other ranges, as long as the chemically strengthened microcrystalline glass with desired performance in the present invention can be obtained.

In some embodiments of the present invention, the chemically strengthened microcrystalline glass has the |CT_AV| of 80-98 MPa. The |CT_AV| refers to an absolute value of an average tensile stress in the tensile stress layer. By enabling the |CT_AV| of the chemically strengthened microcrystalline glass to be 80-98 MPa, it is beneficial to ensure that the chemically strengthened microcrystalline glass has a superior tensile stress distribution structure, so that it has a high surface stress level, and the high surface compressive stress level can offset more remaining energy of drop, extrusion, impact or collision, further ensuring that the chemically strengthened microcrystalline glass has an excellent damage resistance performance.

In some embodiments, the |CT_AV| of the chemically strengthened microcrystalline glass may be 80 MPa, 85 MPa, 90 MPa, 95 MPa, 96.94 MPa, 86.77 MPa, 89.37 MPa, 90.20 MPa, 92.10 MPa, 91.58 MPa, 93.60 MPa or 98 MPa, or may be a numerical value within a numerical range constituted by any two specific numerical values in the above as endpoints, as long as the chemically strengthened microcrystalline glass with desired performance in the present invention can be obtained. It should be understood that in embodiments, any of the above ranges can be combined with any other ranges, as long as the chemically strengthened microcrystalline glass with desired performance in the present invention can be obtained.

In some embodiments of the present invention, the chemically strengthened microcrystalline glass has the |CT_CV| of 115-142 MPa. The |CT_CV| refers to an absolute value of a maximum tensile stress. Preferably, the chemically strengthened microcrystalline glass has the |CT_CV| of 120-140 MPa. By enabling the |CT_CV| of the chemically strengthened microcrystalline glass to be 115-142 MPa, it is beneficial to ensure that the chemically strengthened microcrystalline glass has a high surface stress level, and the high surface compressive stress level can offset more remaining energy of drop, extrusion, impact or collision, further ensuring that the chemically strengthened microcrystalline glass has an excellent damage resistance performance.

In some embodiments, the |CT_CV| of the chemically strengthened microcrystalline glass may be 115 MPa, 120 MPa, 125 MPa, 130 MPa, 135 MPa, 125.68 MPa, 133.49 MPa, 136.28 MPa, 141.54 MPa, 141.63 MPa, 138.76 MPa or 142 MPa, or may be a numerical value within a numerical range constituted by any two specific numerical values in the above as endpoints, as long as the chemically strengthened microcrystalline glass with desired performance in the present invention can be obtained. It should be understood that in embodiments, any of the above ranges can be combined with any other ranges, as long as the chemically strengthened microcrystalline glass with desired performance in the present invention can be obtained.

In some embodiments of the present invention, the Vickers hardness of the chemically strengthened microcrystalline glass is $\geq 680$ kgf/mm$^2$, and preferably, the Vickers hardness of the chemically strengthened microcrystalline glass is 700 kgf/mm$^2$-800 kgf/mm$^2$. By enabling the Vickers hardness of the chemically strengthened microcrystalline glass to be within the above range, the chemically strengthened microcrystalline glass can be endowed with high hardness and high mechanical strength performance, further ensuring it to have an excellent damage resistance performance.

In some embodiments, the Vickers hardness of the chemically strengthened microcrystalline glass may be 680 kgf/mm$^2$, 690 kgf/mm$^2$, 700 kgf/mm$^2$, 710 kgf/mm$^2$, 720 kgf/mm$^2$, 730 kgf/mm$^2$, 740 kgf/mm$^2$, 750 kgf/mm$^2$, 760 kgf/mm$^2$, 770 kgf/mm$^2$, 780 kgf/mm$^2$, 790 kgf/mm$^2$, 726.25 kgf/mm$^2$, 723.96 kgf/mm$^2$, 724.50 kgf/mm$^2$, 720.31 kgf/mm$^2$, 730.98 kgf/mm$^2$, 718.60 kgf/mm$^2$, 731.57 kgf/mm$^2$ or 800 kgf/mm$^2$, or may be a numerical value within a numerical range constituted by any two specific numerical values in the above as endpoints, as long as the chemically strengthened microcrystalline glass with desired performance in the present invention can be obtained. It should be understood that in embodiments, any of the above ranges can be combined with any other ranges, as long as the chemically strengthened microcrystalline glass with desired performance in the present invention can be obtained.

In some embodiments of the present invention, the chemically strengthened microcrystalline glass has the DOL_0 of 0.18 t-0.25 t, where the DOL_0 is the depth of the compression stress layer, t is a thickness of the chemically strengthened microcrystalline glass, and preferably, the chemically strengthened microcrystalline glass has the DOL_0 of 0.20 t-0.25 t. By enabling the chemically strengthened microcrystalline glass to have appropriate DOL_0, sudden cracks caused by impact and piercing of blunt or sharp objects are prevented from directly penetrating the compressive stress region to reach the tensile stress region, resulting in fragmentation of the microcrystalline glass, thereby better facilitating the chemically strengthened microcrystalline glass in offsetting the energy driving the crack propagation, and further ensuring the chemically strengthened microcrystalline glass to have excellent damage resistance performance, such as excellent drop resistance performance.

In some embodiments, the DOL_0 of the chemically strengthened microcrystalline glass may be 0.18 t, 0.20 t, 0.21 t, 0 .22 t, 0 .23 t, 0.24 t or 0 .25 t, or may be a numerical value within a numerical range constituted by any two specific numerical values in the above as endpoints, as long as the chemically strengthened microcrystalline glass with desired performance in the present invention can be obtained. It should be understood that in embodiments, any of the above ranges can be combined with any other ranges, as long as the chemically strengthened microcrystalline glass with desired performance in the present invention can be obtained. Exemplarily, when the thickness of the chemically strengthened microcrystalline glass is 0.7 mm, the DOL_0 of the chemically strengthened microcrystalline glass may be 152.94 $\mu$m, 142.25 $\mu$m, 143.26 $\mu$m, 144.20 $\mu$m, 143.80 $\mu$m, 142.67 $\mu$m, 144.26 $\mu$m, 126 $\mu$m, 130 $\mu$m, 135 $\mu$m, 140 $\mu$m, 150 $\mu$m or 160 $\mu$m, or may be a numerical value within a numerical range constituted by any two specific numerical values in the above as endpoints, as long as the chemically strengthened microcrystalline glass with desired performance in the present invention can be obtained.

In some embodiments of the present invention, the microcrystalline glass or the chemically strengthened microcrystalline glass may be 2D, 2.5D, 3D or special-shaped; and/or the microcrystalline glass or the chemically strengthened microcrystalline glass may have a uniform or non-uniform thickness. Those skilled in the art could make a selection according to requirements. The term "non-uniform thickness" herein refers to that the microcrystalline glass or the chemically strengthened microcrystalline glass includes at least two parts with different thicknesses.

In the present invention, by enabling the chemically strengthened microcrystalline glass to satisfy a specific stress characteristic, the chemically strengthened microcrystalline glass can be ensured to have an excellent physical strength performance, an excellent mechanical strength performance and an excellent damage resistance performance, particularly, an excellent drop damage resistance performance.

In some embodiments of the present invention, an anti-sandpaper drop test is performed on the chemically strengthened microcrystalline glass with a thickness of 0.7 mm using 80-mesh sandpaper. An average anti-sandpaper drop height of the chemically strengthened microcrystalline glass is ≥1.0 m, preferably, the average anti-sandpaper drop height is ≥1.2 m, and more preferably, the average anti-sandpaper drop height is ≥1.5 m. This indicates that the anti-sandpaper drop performance of the chemically strengthened microcrystalline glass of the present invention is excellent. In some embodiments of the present invention, the anti-sandpaper drop test is performed on the chemically strengthened microcrystalline glass with the thickness of 0.7 mm using 80-mesh sandpaper, where the average anti-sandpaper drop height of the chemically strengthened microcrystalline glass may be 1.0 m, 1.1 m, 1.2 m, 1.3 m, 1.4 m, 1.5 m, 1.6 m, 1.7 m, 1.8 m, 1.9 m, 2.0 m, 1.75 m, 1.68 m, 1.64 m, 1.57 m, 1.60 m, 1.62 m, 1.78 m or 2.1 m, etc.

The microcrystalline glass or the chemically strengthened microcrystalline glass having excellent performance provided by the present invention can be used for electronic devices, including, but not limited to, mobile phones, tablet computers, handheld game consoles, portable digital devices (such as digital cameras), vehicle-mounted dashboards, electronic whiteboard glass, intelligent home, and intelligent wearables (such as, smart wristbands, smart watches and smart glasses), can also be used in vehicles, aircrafts or aerocrafts, and can also be used in any glass articles requiring microcrystalline glass. For example, they can be used for display screens, cover glass, touch screens, glass inner screens, inner frames, or the like of electronic devices. For example, they can be used for windshields of vehicles, aircrafts or aerocrafts, such as front windshields or side windshields. For example, they can be used for countertops, other surfaces, appliance doors, floor tiles, wall panels, storage containers, etc. Other surfaces may include, but are not limited to, exterior wall surfaces, stair tread surfaces, pillar facings or counter surfaces, etc. Storage containers may include, but are not limited to, cups, plates, vials or beverage bottles, etc.

Exemplarily, the microcrystalline glass or the chemically strengthened microcrystalline glass having excellent performance provided by the present invention can be used for manufacturing glass articles. The glass articles referred to herein may be regular or irregular, and can be manufactured by those skilled in the art according to demands.

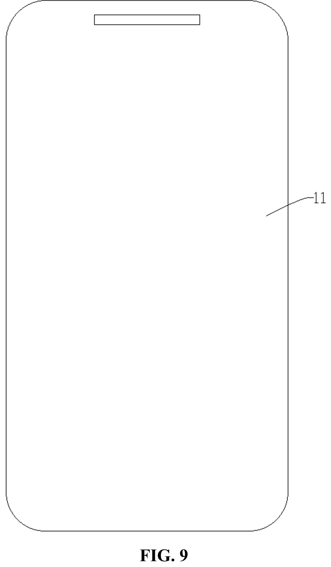

Exemplarily, the microcrystalline glass or the chemically strengthened microcrystalline glass having excellent performance provided by the present invention can be used for manufacturing cover glass, where the cover glass may be a display screen cover plate, a rear housing or a camera protection cover plate of an electronic device. Exemplarily, the microcrystalline glass or the chemically strengthened microcrystalline glass having excellent performance provided by the present invention can be used in electronic devices. With reference to FIG. 9, FIG. 10 and FIG. 11, embodiments of the present invention provide an electronic device. The electronic device may be a mobile phone, or may be an electronic product such as a tablet computer or an intelligent wearable device. The electronic device includes a casing 1 assembled outside the electronic device, and components such as a circuit board and a battery located inside the casing 1. The casing 1 includes a display screen cover plate 11 assembled on a front side and a rear housing 12 assembled on a rear side, where the display screen cover plate 11 is covered over a display module 4. Herein, the display screen cover plate 11 and/or the rear housing 12 can be made of the preceding microcrystalline glass or chemically strengthened microcrystalline glass. In embodiments of the present invention, the display screen cover plate 11 and the rear housing 12 may be completely made of the preceding microcrystalline glass or chemically strengthened microcrystalline glass, or may be only partly made of the preceding microcrystalline glass or chemically strengthened microcrystalline glass. In embodiments of the present invention, the display screen may be a touch display screen, and the display screen cover plate 11 may be a protective cover plate provided on the touch display screen. In embodiments of the present invention, the rear housing 12 may only cover a rear side (i.e., a side away from the display screen) of the electronic device, and may also cover both the rear side and a side frame of the electronic device. Optionally, the rear housing 12 may cover all side frames around the electronic device, and may also cover part of the side frames.

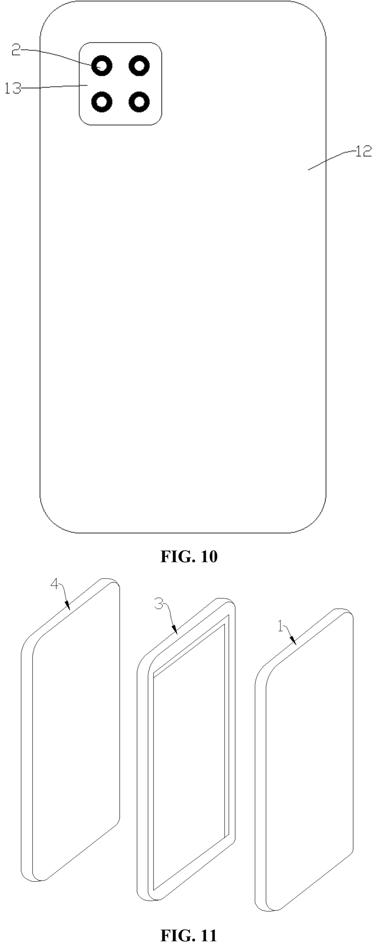

In some embodiments of the present invention, as shown in FIG. 10, the electronic device further includes a camera assembly 2 located inside the casing 1, the casing 1 may include a camera protection cover plate 13, the camera protection cover plate 13 is covered over the camera assembly 2 for protecting the camera assembly 2, and the camera protection cover plate 13 can employ the preceding microcrystalline glass or chemically strengthened microcrystalline glass. In embodiments of the present invention, the camera protection cover plate 13 may partly employ the preceding microcrystalline glass or chemically strengthened microcrystalline glass, or completely employ the preceding microcrystalline glass or chemically strengthened microcrystalline glass. In embodiments of the present invention, a position of the camera protection cover plate 13 may be located on a front side of the electronic device or on a rear side of the electronic device, depending on a position of the camera assembly 2. In some embodiments of the present invention, the camera protection cover plate 13 may be a structure separated from the display screen cover plate 11 or the rear housing 12. In some other embodiments of the present invention, the camera protection cover plate 13 may also be a structure integrated with the display screen cover plate 11 or the rear housing 12.

In some embodiments of the present invention, as shown in FIG. 11, the electronic device further includes a mid-frame 3 located between the display module 4 and the casing 1, where the mid-frame 3 may include the preceding microcrystalline glass or chemically strengthened microcrystalline glass.

In embodiments of the present invention, any one, two, three or four of the display screen cover plate, the rear housing, the camera protection cover plate and the mid-frame in the electronic device may employ the preceding microcrystalline glass or chemically strengthened microcrystalline glass.

In some embodiments of the present invention, the display screen cover plate, the rear housing, the camera protection cover plate or the mid-frame in the electronic device may be 2D, 2.5D, 3D or special-shaped. In some embodiments of the present invention, the display screen cover plate, the rear housing, the camera protection cover plate or the mid-frame in the electronic device may have a uniform or non-uniform thickness.

Those skilled in the art could select the thickness of the microcrystalline glass or the chemically strengthened microcrystalline glass according to demand. Exemplarily, the thickness of the microcrystalline glass or the chemically strengthened microcrystalline glass may be 0.1-5 mm, 0.1-2.0 mm, 0.2-1 mm or 0.4-0.8 mm.

The technical solutions of the present invention are further described in detail below in conjunction with examples. Examples of the present invention described in detail below are illustrative, merely used for explaining the present invention, but should not be construed as limitation to the present invention.

Example 1

(1) Preparation of substrate glass:

Various raw materials (conventional industrial raw materials) were formulated according to formulation proportions in Table 1, with a total mass of the formulated raw materials being 1,000 g, and 5 g of a fining agent, sodium chloride (NaCl), was added to the formulated raw materials, followed by mixing using a V-type mixer for 30 minutes, so as to render a homogenized raw material mixture.

The raw material mixture was transferred into a platinum crucible, and then melted in the platinum crucible at 1,650 °C for 5 hours. Afterward, the resultant was poured into a forming mold to be formed and cooled to 900 °C, followed by annealing in a 500 °C annealing furnace for 24 hours, and cooling to room temperature with the furnace, so as to render a substrate glass brick.

(2) Preparation of microcrystalline glass: the substrate glass brick was put in the annealing furnace, heated from room temperature to 550 °C at a heating rate of 10 °C/min and subjected to a nucleation treatment for 4 h while being insulated at this temperature, then heated to 710 °C at the heating rate of 10 °C/min and subjected to a crystallization treatment for 1.5 h while being insulated at this temperature, and then cooled to room temperature at a cooling rate of 1 °C/min, so as to render a microcrystalline glass sample brick. In terms of molar percentage of oxides, composition of the fabricated microcrystalline glass was identical to that of the substrate glass, as detailed in Table 1.

After the microcrystalline glass sample brick obtained was subjected to cold-working treatments of cutting, CNC machining (CNC instrument model used in the present invention being RCG500S), and polishing in sequence, microcrystalline glass samples meeting required specification and required requirements can be fabricated. In the present invention, the microcrystalline glass sample brick was subjected to the preceding cold-working treatments to fabricate the microcrystalline glass samples with a thickness of 0.70 mm, specifically, 50 mm×50 mm×0.70 mm microcrystalline glass polished sheet samples were fabricated.

The microcrystalline glass samples obtained in Example 1 were tested.

The crystalline phase composition, crystallinity, average grain size, Vickers hardness, and Young's modulus of the microcrystalline glass samples and the optical b value, haze and transmittance (under light with a wavelength of 550 nm) of the microcrystalline glass samples with a thickness of 0.7 mm were tested, and results are respectively listed in Table 2.

(3) Preparation of chemically strengthened microcrystalline glass: the obtained microcrystalline glass samples were preheated in a strengthening furnace cavity for 5 min. After the preheating, the samples were quickly transferred into a 460 °C molten salt bath to undergo a chemical strengthening treatment, where composition of the molten salt included 70 wt% $KNO_3$ + 30 wt% $NaNO_3$ + 0.03 wt% $LiNO_3$ (based on a total mass of $KNO_3$ and $NaNO_3$, adding $LiNO_3$ accounting for 0.03 wt%). After 2 h of chemical strengthening treatment, the microcrystalline glass samples were taken out, slowly cooled on a strengthening furnace body to room temperature, and then washed with clear water to remove salt wrapped on a surface of the microcrystalline glass. After the microcrystalline glass samples were dried, the chemically strengthened microcrystalline glass could be obtained.

The chemically strengthened microcrystalline glass obtained in Example 1 was tested.

I. The chemically strengthened microcrystalline glass was tested by an SLP 2000 stressmeter (employing a light source wavelength of 518 nm, SOC=26 (nm/cm)/MPa, refractive index of 1.56, and exposure time of 300 μsec) for |

CT_CV|, DOL_0, CS_50 and |CT_AV|; and a value of tensile stress linear density (CT_LD) was then calculated, with results listed in Table 3.

II. Vickers hardness of the chemically strengthened microcrystalline glass was tested, and result is listed in Table 3.

III. An average anti-sandpaper drop height of the chemically strengthened microcrystalline glass was tested, and results are listed in Table 3.

Example 2-Example 7

They were carried out with reference to Example 1, except the raw material composition, different process parameters and corresponding test results of various examples as listed in Table 1 to Table 3, respectively.

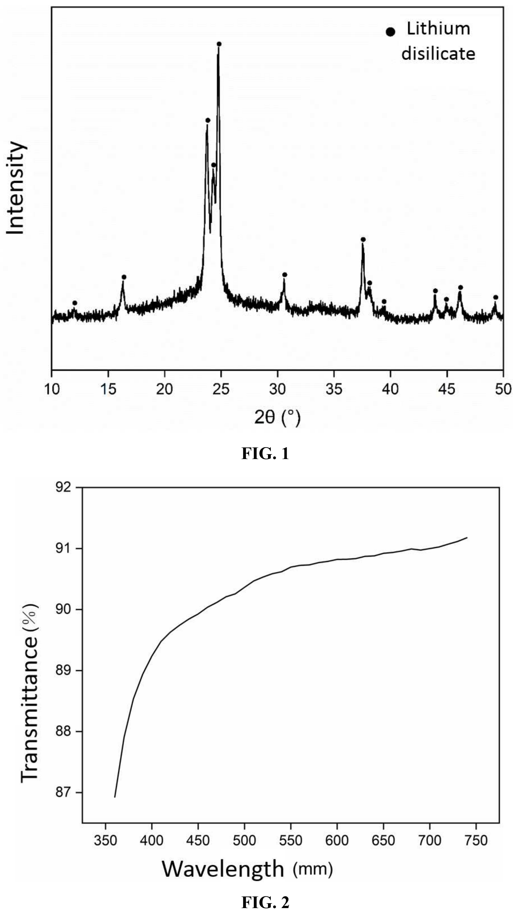

Herein, an XRD pattern of the microcrystalline glass of Example 2 is shown in FIG. 1, from which drawing it can be seen that a predominant crystalline phase in the microcrystalline glass is a lithium disilicate crystalline phase.

A transmittance curve of the microcrystalline glass of Example 2 is shown in FIG. 2, from which drawing it can be seen that the microcrystalline glass is transparent within a visible light range and has a high transmittance.

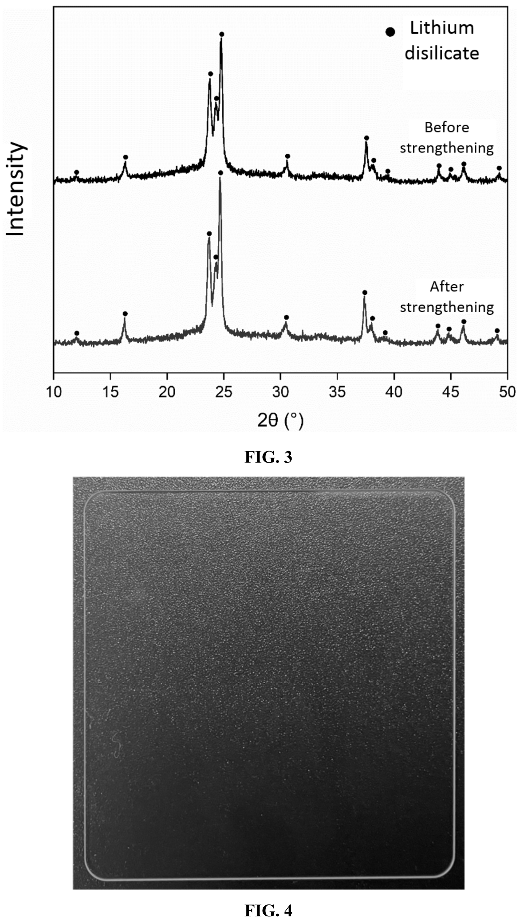

A comparison diagram of XRD patterns of the microcrystalline glass of Example 2 before and after the chemical strengthening is shown in FIG. 3, from which drawing it can be seen that the crystalline phase structure of the microcrystalline glass does not change significantly before and after the chemical strengthening treatment, and the predominant crystalline phase of the chemically strengthened microcrystalline glass produced from the microcrystalline glass is also the lithium disilicate crystalline phase.

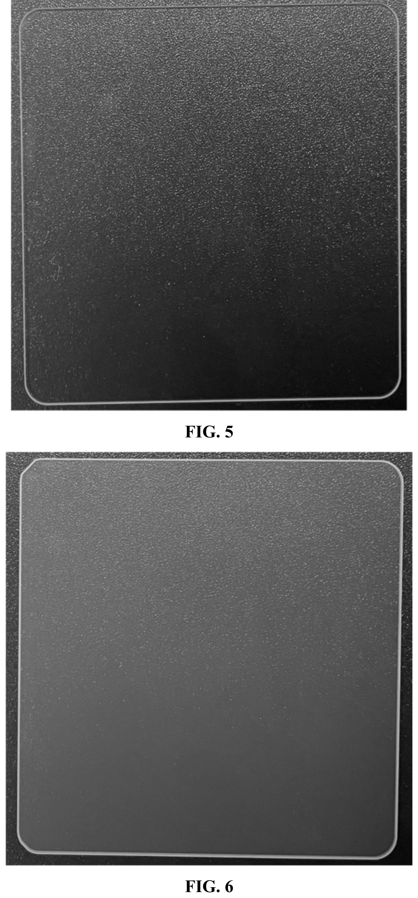

Physical images of the microcrystalline glass of Example 2 and Example 7 are shown in FIG. 4 and FIG. 5, respectively, and the images were taken on a black paper background in order to present a state of microcrystalline glass sheets. It can be seen from the drawings that the microcrystalline glass of the present invention is substantially in a transparent and colorless state due to a small b value, and can achieve a good display effect.

Comparative Example 1-Comparative Example 12

They were carried out with reference to Example 1, except the raw material composition, different process parameters and corresponding test results of various comparative examples as listed in Table 1 to Table 3, respectively.

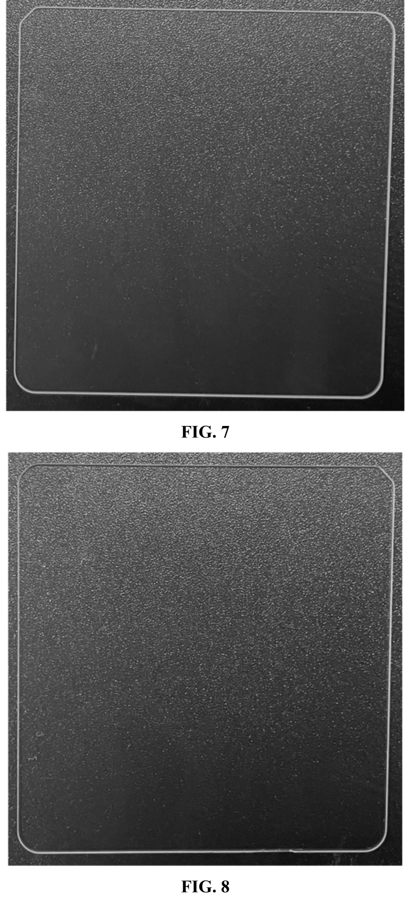

Physical images of the microcrystalline glass of Comparative Example 5, Comparative Example 6 and Comparative Example 8 are shown in FIG. 6, FIG. 7, and FIG. 8, respectively, and the images were taken on a black paper background in order to present a state of microcrystalline glass sheets. It can be seen from the drawings that the microcrystalline glass of the comparative examples is obviously bluish due to a relatively large b value. The larger the b value, the more obvious the blue color presented, and the greater the influence on the display effect.

Table 1

| Oxide/mol% | $SiO_2$ | $Al_2O_3$ | $P_2O_5$ | $ZrO_2$ | $Na_2O$ | $CaO$ | $B_2O_3$ | $Li_2O$ | Z | $[Na_2O]-[B_2O_3]$ | $[Li_2O]/[Na_2O]$ |
|---|---|---|---|---|---|---|---|---|---|---|---|
| Example 1 | 62.88 | 2.86 | 1.40 | 4.80 | 1.85 | 0 | 0.59 | 25.62 | 5.19 | 1.26 | 13.83 |
| Example 2 | 63.26 | 2.87 | 1.41 | 4.33 | 2.36 | 0 | 0 | 25.77 | 5.10 | 2.36 | 10.92 |
| Example 3 | 62.38 | 2.93 | 1.53 | 4.34 | 2.96 | 0 | 0 | 25.87 | 5.09 | 2.96 | 8.73 |
| Example 4 | 62.26 | 2.94 | 1.54 | 4.35 | 3.01 | 0 | 0 | 25.90 | 5.06 | 3.01 | 8.61 |
| Example 5 | 62.45 | 2.94 | 1.54 | 4.35 | 2.93 | 0 | 0 | 25.79 | 5.13 | 2.93 | 8.79 |
| Example 6 | 62.22 | 2.93 | 1.54 | 4.33 | 2.95 | 0 | 0 | 26.03 | 5.09 | 2.95 | 8.83 |
| Example 7 | 63.17 | 2.99 | 1.41 | 4.33 | 2.36 | 0 | 0 | 25.74 | 5.09 | 2.36 | 10.93 |
| Comparative Example 1 | 63.89 | 2.90 | 1.43 | 3.87 | 1.88 | 0 | 0 | 26.03 | 3.87 | 1.88 | 13.83 |
| Comparative Example 2 | 63.37 | 2.88 | 1.41 | 4.34 | 1.87 | 0 | 0.30 | 25.83 | 4.54 | 1.57 | 13.83 |
| Comparative Example 3 | 62.75 | 2.85 | 1.40 | 4.79 | 2.34 | 0 | 0.30 | 25.57 | 5.77 | 2.05 | 10.92 |
| Comparative Example 4 | 63.19 | 2.87 | 1.41 | 3.83 | 2.36 | 0 | 0.59 | 25.75 | 4.77 | 1.76 | 10.92 |
| Comparative Example 5 | 62.62 | 2.85 | 1.40 | 4.78 | 2.83 | 0 | 0 | 25.52 | 5.71 | 2.83 | 9.03 |

(continued)

| Oxide/mol% | $SiO_2$ | $Al_2O_3$ | $P_2O_5$ | $ZrO_2$ | $Na_2O$ | CaO | $B_2O_3$ | $Li_2O$ | Z | $[Na_2O]-[B_2O_3]$ | $[Li_2O]/[Na_2O]$ |
|---|---|---|---|---|---|---|---|---|---|---|---|
| Comparative Example 6 | 63.05 | 2.87 | 1.41 | 3.82 | 2.85 | 0 | 0.30 | 25.70 | 4.69 | 2.55 | 9.03 |
| Comparative Example 7 | 62.56 | 2.84 | 1.40 | 4.29 | 2.82 | 0 | 0.59 | 25.50 | 5.39 | 2.24 | 9.03 |
| Comparative Example 8 | 63.81 | 3.02 | 1.42 | 4.37 | 2.38 | 0 | 0 | 25.00 | 5.16 | 2.38 | 10.51 |
| Comparative Example 9 | 63.94 | 3.02 | 1.23 | 4.38 | 2.38 | 0 | 0 | 25.05 | 5.18 | 2.38 | 10.51 |
| Comparative Example 10 | 63.17 | 2.99 | 1.41 | 4.33 | 2.36 | 0 | 0.99 | 24.75 | 5.55 | 1.36 | 10.51 |
| Comparative Example 11 | 63.17 | 2.99 | 1.41 | 4.33 | 2.36 | 0.99 | 0 | 24.75 | 5.09 | 2.36 | 10.51 |
| Comparative Example 12 | 62.55 | 2.96 | 1.40 | 4.29 | 3.31 | 0 | 0 | 25.49 | 4.57 | 3.31 | 7.70 |

[0236] Note: an oxide content of "0" in Table 1 indicates that the component was not actively or intentionally added to the glass composition during an initial dosing process, but the component may be present as an impurity. In the table, content percentages in oxide mole are put into various equations, and molar unit is not involved in the calculation of the equations.

Table 2

| Microcrystalline Glass | Nucleation Temperature °C | Nucleation Time h | Crystallization Temperature °C | Crystallization Time h | Predominant Crystalline Phase | Crystallinity | Average Grain Size, nm | Young's Modulus, GPa | Vickers Hardness, kgf/mm² | b Value | Transmittance @550 nm | Haze |
|---|---|---|---|---|---|---|---|---|---|---|---|---|
| Example 1 | 550 | 4 | 710 | 1.50 | $Li_2Si_2O_5$ | 59.26% | 28.60 | 106.32 | 660.12 | 0.50 | 90.52% | 0.21% |
| Example 2 | 550 | 4 | 710 | 1.50 | $Li_2Si_2O_5$ | 59.97% | 28.20 | 111.12 | 654.02 | 0.48 | 90.70% | 0.14% |
| Example 3 | 550 | 4 | 715 | 1.50 | $Li_2Si_2O_5$ | 59.69% | 28.80 | 110.82 | 650.20 | 0.47 | 90.64% | 0.16% |
| Example 4 | 550 | 4 | 715 | 1.50 | $Li_2Si_2O_5$ | 59.75% | 29.20 | 111.32 | 652.31 | 0.52 | 90.85% | 0.12% |
| Example 5 | 550 | 4 | 715 | 1.50 | $Li_2Si_2O_5$ | 59.42% | 29.50 | 110.91 | 659.65 | 0.51 | 90.74% | 0.14% |
| Example 6 | 550 | 4 | 715 | 1.50 | $Li_2Si_2O_5$ | 60.14% | 27.60 | 112.10 | 651.70 | 0.54 | 90.63% | 0.16% |
| Example 7 | 550 | 4 | 710 | 1.50 | $Li_2Si_2O_5$ | 59.85% | 28.80 | 111.87 | 654.92 | 0.55 | 90.51% | 0.21% |
| Comparative Example 1 | 550 | 4 | 710 | 1.50 | $Li_2Si_2O_5$ | 60.92% | 34.40 | 114.59 | 653.21 | 1.41 | 89.73% | 0.48% |
| Comparative Example 2 | 550 | 4 | 710 | 1.50 | $Li_2Si_2O_5$ | 60.08% | 40.60 | 109.10 | 664.23 | 2.33 | 88.87% | 0.60% |
| Comparative Example 3 | 550 | 4 | 710 | 1.50 | $Li_2Si_2O_5$ | 59.16% | 46.90 | 108.99 | 668.32 | 2.86 | 88.02% | 1.07% |
| Comparative Example 4 | 550 | 4 | 710 | 1.50 | $Li_2Si_2O_5$ | 60.17% | 44.80 | 109.53 | 669.21 | 2.73 | 87.83% | 1.04% |
| Comparative Example 5 | 550 | 4 | 710 | 1.50 | $Li_2Si_2O_5$ | 59.06% | 52.40 | 117.09 | 658.29 | 2.81 | 87.93% | 1.13% |
| Comparative Example 6 | 550 | 4 | 710 | 1.50 | $Li_2Si_2O_5$ | 60.07% | 54.80 | 104.92 | 659.47 | 1.80 | 88.70% | 0.98% |
| Comparative Example 7 | 550 | 4 | 710 | 1.50 | $Li_2Si_2O_5$ | 59.25% | 61 | 108.91 | 668.47 | 1.68 | 89.21% | 0.63% |
| Comparative Example 8 | 550 | 4 | 710 | 1.50 | $Li_2Si_2O_5$ | 57.64% | 34.90 | 108.00 | 670.27 | 0.82 | 90.28% | 0.23% |
| Comparative Example 9 | 550 | 4 | 710 | 1.50 | $Li_2Si_2O_5$ | 58.65% | 33.20 | 107.05 | 663.21 | 1.85 | 89.06% | 0.77% |
| Comparative Example 10 | 550 | 4 | 710 | 1.50 | $Li_2Si_2O_5$ | 56.97% | 26.70 | 107.65 | 674.95 | 1.14 | 90.08% | 0.28% |

(continued)

| Microcrystalline Glass | Nucleation Temperature °C | Nucleation Time h | Crystallization Temperature °C | Crystallization Time h | Predominant Crystalline Phase | Crystallinity | Average Grain Size, nm | Young's Modulus, GPa | Vickers Hardness, kgf/mm² | b Value | Transmittance @550 nm | Haze |
|---|---|---|---|---|---|---|---|---|---|---|---|---|
| Comparative Example 11 | 550 | 4 | 710 | 1.50 | $Li_2Si_2O_5$ | 57.10% | 33.70 | 109.99 | 670.36 | 1.18 | 90.03% | 0.31% |
| Comparative Example 12 | 550 | 4 | 710 | 1.50 | $Li_2Si_2O_5$ | 59.24% | 35.80 | 108.94 | 674.79 | 0.85 | 90.31% | 0.28% |

Table 3

| Chemically Strengthened Microcrystalline Glass | Salt Bath Composition | Chemical Strengthening Temperature, °C | Chemical Strengthening Time, h | CT-LD, MPa/mm | DOL_0, μm | CS_50, MPa | |CT_AV|, MPa | |CT_CV|, MPa | Vickers Hardness, kgf/mm² | Average Anti-Sandpaper Drop Height, m |
|---|---|---|---|---|---|---|---|---|---|---|
| Example 1 | 70 wt% $KNO_3$ +30 wt% $NaNO_3$ +0.03 wt% $LiNO_3$ | 460 | 2 | 52983.32 | 146.56 | 156.00 | 90.19 | 133.56 | 726.25 | 1.75 |
| Example 2 | | 460 | 3 | 50479.24 | 142.25 | 173.80 | 86.77 | 125.68 | 723.96 | 1.68 |
| Example 3 | | 460 | 3 | 50546.87 | 143.26 | 168.90 | 89.37 | 133.49 | 724.50 | 1.64 |
| Example 4 | | 460 | 3 | 50297.21 | 144.20 | 174.60 | 90.20 | 136.28 | 720.31 | 1.57 |
| Example 5 | | 460 | 2 | 50497.20 | 143.80 | 178.20 | 92.10 | 141.54 | 730.98 | 1.60 |
| Example 6 | | 460 | 2 | 50832.90 | 142.67 | 176.89 | 91.58 | 141.63 | 718.60 | 1.62 |
| Example 7 | | 460 | 2 | 52768.39 | 144.26 | 179.72 | 93.60 | 138.76 | 731.57 | 1.78 |
| Comparative Example 1 | | 460 | 3 | 48730.12 | 159.12 | 170.10 | 88.28 | 133.25 | 730.86 | 1.42 |
| Comparative Example 2 | | 460 | 3 | 49511.53 | 156.97 | 160.68 | 88.74 | 134.57 | 738.35 | 1.40 |
| Comparative Example 3 | | 460 | 2 | 54019.55 | 149.23 | 164.26 | 94.17 | 141.30 | 745.21 | 1.75 |
| Comparative Example 4 | | 460 | 4 | 44664.28 | 158.10 | 163.46 | 78.39 | 114.99 | 751.20 | 1.27 |
| Comparative Example 5 | | 460 | 3 | 57133.28 | 152.62 | 148.03 | 92.21 | 148.70 | 745.80 | 1.89 |
| Comparative Example 6 | | 460 | 2 | 44428.09 | 144.61 | 158.08 | 75.38 | 107.17 | 730.45 | 1.29 |
| Comparative Example 7 | | 460 | 3 | 48135.83 | 150.86 | 132.98 | 87.19 | 131.32 | 740.67 | 1.48 |
| Comparative Example 8 | | 460 | 2 | 50403.40 | 141.48 | 190.21 | 85.41 | 120.25 | 745.21 | 1.60 |
| Comparative Example 9 | | 460 | 4 | 52841.93 | 147.38 | 165.06 | 92.21 | 138.74 | 739.57 | 1.69 |

| Chemically Strengthened Microcrystalline Glass | Salt Bath Composition | Chemical Strengthening Temperature, °C | Chemical Strengthening Time, h | CT-LD, MPa/mm | DOL_0, μm | CS_50, MPa | \|CT_AV\|, MPa | \|CT_CV\|, MPa | Vickers Hardness, kgf/mm$^2$ | Average Anti-Sandpaper Drop Height, m |
|---|---|---|---|---|---|---|---|---|---|---|
| Comparative Example 10 | | 460 | 2 | 51356.69 | 142.15 | 182.13 | 84.88 | 120.83 | 745.63 | 1.65 |
| Comparative Example 11 | | 460 | 2 | 52622.80 | 146.60 | 151.54 | 90.15 | 129.33 | 748.81 | 1.62 |
| Comparative Example 12 | | 460 | 2 | 50872.40 | 138.68 | 173.98 | 85.02 | 119.60 | 743.08 | 1.63 |

As can be obtained from the examples and comparative examples in Tables 1-3, compared with the comparative examples, the solutions of the examples of the present invention are employed, in which by controlling the composition and proportioning relationships of various components of the microcrystalline glass, while satisfying content ranges of various oxides, controlling specific ranges of the molar percentage relationships between $Na_2O$, $B_2O_3$, $ZrO_2$ or $Li_2O$, and enabling the microcrystalline glass to be formed with the microstructure with lithium disilicate as the predominant crystalline phase at the same time, the microcrystalline glass is endowed with excellent optical properties (such as high transmittance, low haze and low b value) and high intrinsic strength (such as high Young's modulus and high Vickers hardness), and the microcrystalline glass can be ensured to achieve rapid and efficient production of the chemically strengthened microcrystalline glass having a high stress level and high mechanical strength under conventional chemical strengthening conditions. The chemically strengthened microcrystalline glass produced in the examples of the present invention has high CS_50, |CT_AV|, DOL_0 and CT_LD, and has excellent drop resistance performance.

However, in the solutions of Comparative Example 1-Comparative Example 12, the glass formulas thereof did not simultaneously satisfy the content ranges of various oxides in the present invention or the molar percentage relationships between $Na_2O$, $B_2O_3$, $ZrO_2$ or $Li_2O$. Finally, in the solutions of various comparative examples, the fabricated microcrystalline glass either had relatively poor optical properties, for example, the microcrystalline glass had a low transmittance, high optical b value or high haze, or under the same chemical strengthening process conditions, the fabricated chemically strengthened microcrystalline glass exhibited inferior stress performance to the solutions of the examples and deteriorated drop resistance performance. That is, as the solutions of the comparative examples did not simultaneously satisfy the requirements of the solutions of the present invention, they failed to have both excellent optical properties and high stress level.

The above-mentioned are merely for specific embodiments of the present invention and not used to limit the present invention, and for those skilled in the art, various modifications and changes could be made to the present invention. Any modifications, equivalent substitutions, improvements and so on made within the spirit and principle of the present invention should be covered within the scope of protection of the present invention.

**INDUSTRIAL APPLICABILITY**

By controlling the specific composition and crystalline phase structure of the microcrystalline glass, specific ranges of contents of various components of the microcrystalline glass and the proportioning relationship between the contents of various components, specific molar percentage relationships between $Na_2O$, $B_2O_3$, $ZrO_2$ or $Li_2O$, and lithium disilicate as a predominant crystalline phase of the microcrystalline glass at the same time, the present invention not only can endow the microcrystalline glass with excellent optical properties and high intrinsic strength, but also enables the microcrystalline glass to achieve rapid and efficient production of the chemically strengthened microcrystalline glass having a high stress level and high mechanical strength performance under conventional chemical strengthening process conditions, thereby being capable of effectively reducing production costs of the high-strength chemically strengthened microcrystalline glass.

**Claims**

1. A microcrystalline glass, **characterized in that** the microcrystalline glass comprises a lithium disilicate crystalline phase, wherein the lithium disilicate crystalline phase has a higher weight percentage than other crystalline phases present in the microcrystalline glass;

    in terms of molar percentage of oxides, the microcrystalline glass comprises components as follows: $SiO_2$: 61.50%-63.40%, $Al_2O_3$: 2.75%-2.99%, $P_2O_5$: 0.91%-1.91%, $ZrO_2$: 4.20%-4.85%, $Na_2O$: 1.80%-3.20%, $B_2O_3$: 0-1.00% and $Li_2O$: 25.32%-26.52%; and
    in composition of the microcrystalline glass, a molar percentage [$Na_2O$] of $Na_2O$, a molar percentage [$B_2O_3$] of $B_2O_3$ and a molar percentage [$ZrO_2$] of $ZrO_2$ satisfy a following relationship:

$$Z=-1.344\times(2.65-100\times[Na_2O])^2+0.466\times100\times[B_2O_3]+1.203\times100\times[ZrO_2],$$

    where $4.80\leq Z\leq5.35$, preferably, $4.98\leq Z\leq5.20$.

2. The microcrystalline glass according to claim 1, wherein in the composition of the microcrystalline glass, the molar percentage [$Na_2O$] of $Na_2O$ and the molar percentage [$B_2O_3$] of $B_2O_3$ satisfy a following relationship:

$$0.90\% \leq [Na_2O]-[B_2O_3] \leq 3.10\%,$$

preferably $1.25\% \leq [Na_2O]-[B_2O_3] \leq 3.02\%$, and more preferably $2.00\% \leq [Na_2O]-[B_2O_3] \leq 3.00\%$.

3. The microcrystalline glass according to claim 1 or 2, wherein in the composition of the microcrystalline glass, the molar percentage $[Na_2O]$ of $Na_2O$ and the molar percentage $[Li_2O]$ of $Li_2O$ satisfy a following relationship:

$$8.55 \leq [Li_2O]/[Na_2O] \leq 13.85,$$

preferably $8.55 \leq [Li_2O]/[Na_2O] \leq 11.50$.

4. The microcrystalline glass according to any one of claims 1-3, wherein the lithium disilicate crystalline phase accounts for 70% or more by weight of all crystalline phases of the microcrystalline glass, and preferably, the lithium disilicate crystalline phase accounts for 85% or more by weight of all the crystalline phases of the microcrystalline glass.

5. The microcrystalline glass according to any one of claims 1-4, wherein in terms of molar percentage of oxides, in the microcrystalline glass:

a molar percentage of $SiO_2$ is 61.50%-63.30%, preferably, the molar percentage of $SiO_2$ is 62.00%-62.60%; and/or
a molar percentage of $P_2O_5$ is 1.20%-1.91%, and preferably, the molar percentage of $P_2O_5$ is 1.30%-1.60%; and/or
the molar percentage of $Na_2O$ is 1.85%-3.05%, and preferably, the molar percentage of $Na_2O$ is 2.20%-3.00%; and/or
the molar percentage of $B_2O_3$ is 0-0.65%; and/or the molar percentage of $ZrO_2$ is 4.20%-4.80%; and/or
a molar percentage of $Li_2O$ is 25.52%-26.52%, and preferably, the molar percentage of $Li_2O$ is 25.52%-26.00%.

6. The microcrystalline glass according to any one of claims 1-4, wherein in terms of molar percentage of oxides, in the microcrystalline glass:

a molar percentage of $SiO_2$ is 62.88%, 63.30%, 62.50%, 63.26%, 62.38%, 62.27%, 62.45%, 62.22% or 63.17%; and/or
a molar percentage of $Al_2O_3$ is 2.86%, 2.87%, 2.93%, 2.94% or 2.99%; and/or
a molar percentage of $P_2O_5$ is 1.00%, 1.20%, 1.30%, 1.60%, 1.40%, 1.41%, 1.53% or 1.54%; and/or
a molar percentage of $ZrO_2$ is 4.80%, 4.74%, 4.84%, 4.33%, 4.34% or 4.35%; and/or
a molar percentage of $Na_2O$ is 1.85%, 2.35%, 1.95%, 2.36%, 2.96%, 3.01%, 2.93% or 2.95%; and/or
a molar percentage of $Li_2O$ is 25.62%, 25.82%, 25.69%, 25.36%, 25.77%, 25.87%, 25.90%, 25.79%, 26.03% or 25.74%.

7. The microcrystalline glass according to any one of claims 1-6, wherein in terms of content expressed in molar percentage of oxides, the composition of the microcrystalline glass satisfies:

a value of equation Z is 5.19, 5.10, 5.09, 5.06 or 5.13; and/or
a value of $[Na_2O]-[B_2O_3]$ is 1.26%, 1.79%, 0.96%, 2.36%, 2.96%, 3.01%, 2.93% or 2.95%; and/or
a value of $[Li_2O]/[Na_2O]$ is 13.83, 10.93, 13.01, 10.92, 8.73, 8.61, 8.79 or 8.83.

8. The microcrystalline glass according to any one of claims 1-7, wherein crystallinity of the microcrystalline glass is not lower than 45%, preferably, the crystallinity of the microcrystalline glass is 45%-85%, and more preferably, the crystallinity of the microcrystalline glass is 55%-65%; and/or
in the microcrystalline glass, an average grain size is not larger than 100 nm, preferably, the average grain size is not larger than 40 nm, and more preferably, the average grain size is 15-30 nm.

9. The microcrystalline glass according to any one of claims 1-8, wherein the microcrystalline glass is transparent within a visible light wavelength range; preferably, at a thickness of 0.70 mm, for light with a wavelength of 550 nm, transmittance of the microcrystalline glass is $\geq 90.00\%$, and preferably the transmittance is >90.40%; and/or at the thickness of 0.7 mm, haze of the microcrystalline glass is <0.30%.

10. The microcrystalline glass according to any one of claims 1-9, wherein at a thickness of 0.70 mm, a b value of the microcrystalline glass is <0.70, and preferably, the b value is ≤0.60.

11. The microcrystalline glass according to any one of claims 1-10, wherein Young's modulus of the microcrystalline glass is ≥100 GPa, and preferably, the Young's modulus of the microcrystalline glass is 105-112.50 GPa; and/or Vickers hardness of the microcrystalline glass is ≥640 kgf/mm$^2$, and preferably, the Vickers hardness of the microcrystalline glass is 640-680 kgf/mm$^2$.

12. The microcrystalline glass according to any one of claims 1-11, wherein the microcrystalline glass comprises planar microcrystalline glass or curved microcrystalline glass; and preferably, when the microcrystalline glass is the curved microcrystalline glass, the microcrystalline glass can be fabricated by performing a 3D hot bending treatment on a crystallized glass precursor with crystallinity not lower than 5%.

13. The microcrystalline glass according to any one of claims 1-12, wherein the microcrystalline glass is fabricated from substrate glass through a heat treatment; preferably, the heat treatment process comprises a nucleation treatment and/or a crystallization treatment; preferably, the crystallization treatment comprises one-step crystallization treatment or two-step crystallization treatment; preferably, a curved microcrystalline glass can be fabricated through the two-step crystallization treatment, wherein when the two-step crystallization treatment is employed, a second step of the crystallization treatment comprises heating a crystallized glass precursor obtained from a first step of crystallization treatment to a crystallization temperature and performing a 3D hot bending treatment.

14. A chemically strengthened microcrystalline glass, **characterized in that** composition at a center of the chemically strengthened microcrystalline glass is identical to that of the microcrystalline glass according to any one of claims 1-13, and the chemically strengthened microcrystalline glass comprises a compression stress layer and a tensile stress layer.

15. The chemically strengthened microcrystalline glass according to claim 14, wherein the chemically strengthened microcrystalline glass comprises a lithium disilicate crystalline phase, wherein the lithium disilicate crystalline phase accounts for a higher weight percentage than other crystalline phases present in the chemically strengthened microcrystalline glass; and in terms of molar percentage of oxides, the component at the center of the chemically strengthened microcrystalline glass comprises: $SiO_2$: 61.50%-63.40%, $Al_2O_3$: 2.75%-2.99%, $P_2O_5$: 0.91%-1.91%, $ZrO_2$: 4.20%-4.85%, $Na_2O$: 1.80%-3.20%, $B_2O_3$: 0-1.00% and $Li_2O$: 25.32%-26.52%; and in the composition at the center of the chemically strengthened microcrystalline glass, a molar percentage $[Na_2O]$ of $Na_2O$, a molar percentage $[B_2O_3]$ of $B_2O_3$ and a molar percentage $[ZrO_2]$ of $ZrO_2$ satisfy a following relationship:

$$Z=-1.344\times(2.65-100\times[Na_2O])^2+0.466\times100\times[B_2O_3]+1.203\times100\times[ZrO_2],$$

4.80≤Z≤5.35, preferably, 4.98≤Z≤5.20.

16. The chemically strengthened microcrystalline glass according to claim 14 or 15, wherein in the composition at the center of the chemically strengthened microcrystalline glass, the molar percentage $[Na_2O]$ of $Na_2O$ and the molar percentage $[B_2O_3]$ of $B_2O_3$ satisfy a following relationship:

$$0.90\%\leq[Na_2O]-[B_2O_3]\leq3.10\%,$$

preferably, 1.25%≤$[Na_2O]$-$[B_2O_3]$≤3.02%, and more preferably, 2.00%≤$[Na_2O]$-$[B_2O_3]$≤3.00%; and/or in the composition at the center of the chemically strengthened microcrystalline glass, the molar percentage $[Na_2O]$ of $Na_2O$ and the molar percentage $[Li_2O]$ of $Li_2O$ satisfy a following relationship:

$$8.55\leq[Li_2O]/[Na_2O]\leq13.85,$$

and preferably, 8.55≤$[Li_2O]$/$[Na_2O]$≤11.50.

17. The chemically strengthened microcrystalline glass according to any one of claims 14-16, wherein the chemically strengthened microcrystalline glass has CT_LD of 45,000-55,000 MPa/mm, wherein the CT_LD is tensile stress linear density, and preferably, the chemically strengthened microcrystalline glass has the CT_LD of 48,000-53,000 MPa/mm; and/or

the chemically strengthened microcrystalline glass has DOL_0 of 0.18 t-0.25 t, wherein the DOL_0 is a depth of the compression stress layer, and t is a thickness of the chemically strengthened microcrystalline glass, and preferably, the chemically strengthened microcrystalline glass has the DOL_0 of 0.20 t-0.25 t; and/or

the chemically strengthened microcrystalline glass has CS_50 of 150-199 MPa, wherein the CS_50 refers to a compressive stress value at a depth of 50 $\mu$m from a main surface of the chemically strengthened microcrystalline glass, and preferably, the chemically strengthened microcrystalline glass has the CS_50 of 160-199 MPa; and/or

the chemically strengthened microcrystalline glass has |CT_AV| of 80-98 MPa, wherein the |CT_AV| is an absolute value of an average tensile stress; and/or

the chemically strengthened microcrystalline glass has |CT_CV| of 115-142 MPa, wherein the |CT_CV| is an absolute value of a maximum tensile stress, and preferably, the chemically strengthened microcrystalline glass has the |CT_CV| of 120-140 MPa.

18. The chemically strengthened microcrystalline glass according to any one of claims 14-17, wherein Vickers hardness of the chemically strengthened microcrystalline glass is larger than or equal to 680 kgf/mm$^2$, and preferably, the Vickers hardness of the chemically strengthened microcrystalline glass is 700 kgf/mm$^2$-800 kgf/mm$^2$.

19. A cover glass, **characterized in that** the cover glass comprises the microcrystalline glass according to any one of claims 1-13 or the chemically strengthened microcrystalline glass according to any one of claims 14-18.

20. An electronic device, **characterized in that** the electronic device comprises the microcrystalline glass according to any one of claims 1-13 or the chemically strengthened microcrystalline glass according to any one of claims 14-18.

21. The electronic device according to claim 20, wherein the electronic device comprises a casing assembled outside the electronic device, and a circuit board located inside the casing, wherein the casing comprises the microcrystalline glass according to any one of claims 1-13 or the chemically strengthened microcrystalline glass according to any one of claims 14-18.

22. The electronic device according to claim 21, wherein the casing comprises a display screen cover plate assembled on a front side of the electronic device, wherein the display screen cover plate comprises the microcrystalline glass according to any one of claims 1-13 or the chemically strengthened microcrystalline glass according to any one of claims 14-17.

23. The electronic device according to claim 21 or 22, wherein the casing comprises a rear housing assembled on a rear side of the electronic device, wherein the rear housing comprises the microcrystalline glass according to any one of claims 1-13 or the chemically strengthened microcrystalline glass according to any one of claims 14-18.

24. The electronic device according to any one of claims 21-23, wherein the electronic device further comprises a camera assembly located inside the casing, and the casing comprises a camera protection cover plate, wherein the camera protection cover plate is covered over the camera assembly, and the camera protection cover plate comprises the microcrystalline glass according to any one of claims 1-13 or the chemically strengthened microcrystalline glass according to any one of claims 14-18.

25. The electronic device according to any one of claims 20-24, wherein the electronic device further comprises a mid-frame, wherein the mid-frame comprises the microcrystalline glass according to any one of claims 1-13 or the chemically strengthened microcrystalline glass according to any one of claims 14-18.

**FIG. 1**

**FIG. 2**

**FIG. 3**

**FIG. 4**

**FIG. 5**

**FIG. 6**

**FIG. 7**

**FIG. 8**

**FIG. 9**

**FIG. 10**

**FIG. 11**

## INTERNATIONAL SEARCH REPORT

| International application No. |
|---|
| **PCT/CN2024/144670** |

| A. | CLASSIFICATION OF SUBJECT MATTER |
|---|---|

C03C10/04(2006.01)i; H05K5/03(2006.01)i; H05K5/02(2006.01)i; C03C21/00(2006.01)i

According to International Patent Classification (IPC) or to both national classification and IPC

| B. | FIELDS SEARCHED |
|---|---|

Minimum documentation searched (classification system followed by classification symbols)

    IPC: C03C, H05K

Documentation searched other than minimum documentation to the extent that such documents are included in the fields searched

Electronic data base consulted during the international search (name of data base and, where practicable, search terms used)

CNABS, CNTXT, ENTXTC, WPABS, DWPI, ENTXT, 中国期刊网全文数据库, CJFD, ISI Web of Science: 重庆鑫景, 龙晨晖, 微晶, 结晶, 晶化, 玻璃, 化学强化, 离子交换, 二硅酸锂, 氧化钠, 氧化锂, 氧化硼, 三氧化二硼, 氧化锆, +crystal+, glass, chemical strength+, ion exchange, Li2Si2O5, lithium disilicate, Na2O, Li2O, B2O3, ZrO2

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 118290031 A (CHONGQING XINJING SPECIAL GLASS CO., LTD.) 05 July 2024 (2024-07-05) <br> claims 1-25 | 1-25 |
| PX | CN 118702411 A (CHONGQING XINJING SPECIAL GLASS CO., LTD.) 27 September 2024 (2024-09-27) <br> claims 1-27 | 1-25 |
| X | WO 2023090177 A1 (NIPPON ELECTRIC GLASS CO., LTD.) 25 May 2023 (2023-05-25) <br> description, paragraphs 4, 7, 19-23, 48, and 76-91 | 1-25 |
| X | CN 112166091 A (NIPPON ELECTRIC GLASS CO., LTD.) 01 January 2021 (2021-01-01) <br> description, paragraphs 23-66, and embodiments No.1-No.5 | 1-25 |
| A | CN 115772003 A (SHENZHEN WEISITENG NEW MATERIAL TECHNOLOGY CO., LTD.) 10 March 2023 (2023-03-10) <br> entire document | 1-25 |
| A | CN 113387586 A (CDGM GLASS CO., LTD.) 14 September 2021 (2021-09-14) <br> entire document | 1-25 |

☐ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **18 March 2025** | **24 March 2025** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/144670**

| Patent document cited in search report | | | Publication date (day/month/year) | Patent family member(s) | | | Publication date (day/month/year) |
|---|---|---|---|---|---|---|---|
| CN | 118290031 | A | 05 July 2024 | None | | | |
| CN | 118702411 | A | 27 September 2024 | None | | | |
| WO | 2023090177 | A1 | 25 May 2023 | CN | 118265680 | A | 28 June 2024 |
| | | | | EP | 4434948 | A1 | 25 September 2024 |
| | | | | US | 2025026680 | A1 | 23 January 2025 |
| | | | | KR | 20240101594 | A | 02 July 2024 |
| CN | 112166091 | A | 01 January 2021 | JP | 2024098122 | A | 19 July 2024 |
| | | | | WO | 2019230889 | A1 | 05 December 2019 |
| | | | | JP | 7498894 | B2 | 13 June 2024 |
| | | | | US | 2021214269 | A1 | 15 July 2021 |
| | | | | CN | 115196874 | A | 18 October 2022 |
| | | | | CN | 117069372 | A | 17 November 2023 |
| CN | 115772003 | A | 10 March 2023 | None | | | |
| CN | 113387586 | A | 14 September 2021 | None | | | |

Form PCT/ISA/210 (patent family annex) (July 2022)

**EP 4 674 822 A1**

**Patent documents cited in the description**

- CN 202410175049
- GB 379002019 T
- GB 7962122010 T

**Non-patent literature cited in the description**

- **ROBERT L. SMITH** ; **GEORGE E. SANDLAND**. *Vickers Ltd.*, 1921